# EUROPEAN PATENT APPLICATION

(11) **EP 2 475 066 A1**
(43) Date of publication of application: **11.07.2012**
(21) Application number: 10811532.0
(22) Date of filing: 27.08.2010
(51) Int. Cl.: H02J 7/02, B60L 3/00, G01R 31/36, H01M 2/10, H01M 2/20, H01M 10/42, H01M 10/48, H02J 7/00, H02J 7/10

(54) **BATTERY MODULE, BATTERY SYSTEM AND ELECTRICALLY DRIVEN VEHICLE**

(30) Priority: 31.08.2009 JP 2009199301
(71) Applicant: Sanyo Electric Co., Ltd., Moriguchi City, Osaka 570-8677 (JP)
(72) Inventor: KUNIMITSU, Tomonori, Moriguchi-City Osaka 570-8677 (JP); NISHIHARA, Yoshitomo, Moriguchi-City Osaka 570-8677 (JP); MURAO, Hiroya, Moriguchi-City Osaka 570-8677 (JP); KISHIMOTO, Keiji, Moriguchi-City Osaka 570-8677 (JP); OHKURA, Kazumi, Moriguchi-City Osaka 570-8677 (JP)
(74) Representative: Calderbank, Thomas Roger
(86) International application number: PCT/JP2010/005309
(87) International publication number: WO 2011/024477

(57) **Abstract**

A battery module includes a plurality of battery cells, a detection circuit, a communication unit, and a printed circuit board. The detection circuit and the communication circuit are mounted on the common printed circuit board. The detection circuit detects a voltage of each of the battery cells in the battery module, and feeds the detected voltage to the communication circuit. The communication circuit is connected to a communication circuit in another battery module or a battery ECU. Thus, the communication circuit in the battery module and the communication circuit in the other battery module or the battery ECU can communicate with each other.

## Description

### [Technical Field]

The present invention relates to a battery module, a battery system and an electric vehicle including the same.

### [Background Art]

Chargeable and dischargeable battery modules are used as driving sources of movable objects such as electric automobiles. Such battery modules have each a configuration in which a plurality of batteries (battery cells) are connected in series, for example.

Users of the movable objects including the battery modules are required to grasp the remaining amounts (charged capacities) of the battery modules.

Patent Document 1 discusses a monitoring device of an assembled battery. The assembled battery includes a plurality of battery modules. Each of the battery modules includes a plurality of battery cells, composed of a nickel metal hydride battery, connected in series.

The monitoring device includes a plurality of voltage measuring units respectively connected to the plurality of battery modules, and an ECU (Electronic Control Unit). Each of the voltage measuring units detects a voltage between both terminals of the corresponding battery module (a voltage between a positive polarity terminal of the battery cell on the highest potential side and a negative polarity terminal of the battery cell on the lowest potential side), and transmits the detected voltage to the ECU via a serial transmission line.
[Patent Document 1] JP 8-162171 A

### [Summary of Invention]

### [Technical Problem]

In the monitoring device discussed in Patent Document 1, the ECU can grasp a voltage of each of the battery modules. Thus, charge and discharge of each of the battery modules can be controlled based on the voltage of each of the battery modules.

In recent years, a battery module using a lithium-ion battery as a plurality of battery cells has been developed. The lithium-ion battery more easily deteriorates in characteristic due to overcharge and overdischarge than a nickel metal hydride battery.

On the other hand, the plurality of battery cells vary in charge and discharge characteristics. Therefore, it is desired to individually control charges and discharges of the battery cells to prevent each of the battery cells from being overcharged and overdischarged.

However, in the monitoring device discussed in Patent Document 1, described above, the ECU cannot grasp the voltage of each of the battery cells included in each of the battery modules. Therefore, the charges and discharges of the battery cells cannot individually be controlled based on the voltage of each of the battery cells.

An object of the present invention is to provide a battery module capable of intensively managing a voltage between terminals of each of battery cells included in a plurality of battery modules, a battery system including the same, and an electric vehicle.

### [Solution to Problem]

According to an aspect of the present invention, a battery module (a battery module 100, 100A to 100F) that can communicate with an external apparatus (a battery module 100, 100A to 100F, or a battery ECU 101) includes a plurality of battery cells (battery cells 10), a detector (a detection circuit 20) that detects a voltage of each of the battery cells, a communication unit (a communication circuit 24) that is connected to the detector while being connectable to the external apparatus, and a common circuit board (a printed circuit board 21, 21a to 21c) on which the detector and the communication unit are mounted, in which the communication unit is operable to transmit the voltage of each of the battery cells detected by the detector to the external apparatus.

In the battery module according to the aspect of the present invention, the detector detects the voltage of each of the battery cells, and the communication unit transmits the detected voltage of each of the battery cells to the external apparatus.

The detector and the communication unit are mounted on the common circuit board. Therefore, a wiring between the detector and the communication unit becomes short and simple. Thus, an arrangement space of the detector and the communication unit becomes small.

As a result, a voltage between terminals of each of the battery cells can be intensively managed without increasing the size of the battery module.

The battery module may further include a connecting member (a bus bar 40, 40p, and a voltage/current bus bar 40y) that connects electrodes (plus electrodes 10a or minus electrodes 10b) of the adjacent battery cells to each other, a first wiring (a conductor line 52) that connects the detector with the connecting member, and a second wiring (a conductor line 54, 55 or communication lines 56 and 58) that connects the communication unit with another battery module, in which the first wiring and the second wiring may be pulled out in the same direction from the circuit board.

In this case, the first wiring and the second wiring are arranged to concentrate in one direction of the circuit board. Thus, the circuit board becomes easy to handle, and the battery module becomes easy to assemble. Since the first wiring and the second wiring do not exist around the circuit board, excluding the one direction, heat dissipation characteristics of the detector and the communication unit are improved.

The connecting member may include a plurality of connecting members, the first wiring may include a plurality of first wirings provided to correspond to the plurality of connecting members, and at least parts of the plurality of first wirings and the second wiring may be pulled out in the same direction from the circuit board.

In this case, at least parts of the plurality of first wirings and the second wiring are arranged to concentrate in one direction of the circuit board. Even when the plurality of first wirings are provided, therefore, the circuit board becomes easy to handle, and the battery module becomes easy to assemble. At least parts of the plurality of first wirings and the second wiring concentrate in one direction. When the plurality of first wirings are provided, therefore, heat dissipation characteristics of the detector and the communication unit are improved.

The battery module may further include a temperature detector (a thermistor 11) that detects temperatures of the plurality of battery cells, a third wiring (a conductor line 53) that connects the communication unit with the temperature detector, and a flexible member (an FPC board 50, 50a, 50b) that is provided with the first wiring, the second wiring, and the third wiring.

In this case, the communication unit transmits the temperature detected by the temperature detector to the external apparatus. Since the first wiring, the second wiring, and the third wiring are provided in the flexible member, the first wiring, the second wiring, and the third wiring can be integrally handled. Thus, the battery module becomes easier to assemble. Since the first wiring, the second wiring, and the third wiring concentrate on the flexible member, a space where the first wiring, the second wiring, and the third wiring do not exist is kept large around the plurality of battery cells. Thus, heat dissipation characteristics of the plurality of battery cells are improved.

The circuit board may include a first region (a first mounting region 10G) in which the detector is mounted while a first ground conductor (a ground pattern GND1) for the plurality of battery cells is formed, a second region (a second mounting region 12G) in which the communication unit is mounted while a second ground conductor (a ground pattern GND2) for an external power source (a non-driving battery 12) is formed, a third region (an insulating region 26) for electrically insulating the first region and the second region, and an insulating element (an insulating element 25) that connects the detector with the communication unit so that they can communicate with each other while being electrically insulated from each other.

In this case, the first ground conductor formed in the first region of the circuit board and the second ground conductor formed in the second region of the circuit board are reliably electrically insulated from each other by the third region while the detector mounted on the first region and the communication unit mounted on the second region are reliably electrically insulated from each other by the insulating element. Thus, the plurality of battery cells can be used as a power source of the detector, and the external power source can be used as a power source of the communication unit. As a result, the detector and the communication unit can be independently stably operated.

According to another aspect of the present invention, a battery system (a battery system 500) includes the battery module (a battery module 100, 100A to 100F) according to the aspect of the present invention, and a controller (a battery ECU 101) that controls charge and discharge of each of the plurality of battery cells (battery cells 10), in which a communication unit (a communication circuit 24) in each of the battery modules is connected to a communication unit in the other battery module, and the controller is connected to the communication unit in any one of the battery modules.

In the battery system according to the other aspect of the present invention, the voltage of each of the battery cells detected by the detector in each of the battery modules is transmitted to the communication unit in the other battery module by the communication unit in the battery module. The communication unit in any one of the battery modules transmits the voltage of each of the battery cells in the plurality of battery modules. Thus, the controller can intensively manage the voltage of each of the battery cells in the plurality of battery modules.

The controller can individually control the charges and discharges of the battery cells in the plurality of battery modules based on the voltage of each of the battery cells in the plurality of battery modules. Therefore, the charged capacities of the plurality of battery cells in the plurality of battery modules can be kept substantially equal. Thus, parts of the battery cells can be prevented from being overcharged and overdischarged. As a result, the battery cells can be prevented from deteriorating.

In this case, the controller can acquire the voltage of each of the battery cells in the plurality of battery modules by being connected to not all the battery modules but any of the battery modules. Therefore, a wiring is simplified.

According to still another aspect of the present invention, an electric vehicle (an electric automobile 600) includes the battery system (a battery system 500) according to another aspect of the present invention, a motor (a motor 602) that is driven by electric power form the battery module (battery module 100, 100A to 100F) in the battery system, and a drive wheel (a drive wheel 603) that rotates by a torque generated by the motor.

In the electric vehicle according to the still other aspect of the present invention, the motor is driven by the electric power from the battery module. The drive wheel rotates by the torque generated by the motor so that the electric vehicle moves.

The battery system according to the other aspect of the present invention is used so that the controller can intensively manage the voltage of each of the battery cells in the plurality of battery modules while the battery cell can be prevented from deteriorating. Thus, the reliability of the battery module can be improved, and the life thereof can be lengthened. As a result, the performance of the electric vehicle can be improved while the cost thereof can be reduced.

The battery module further includes a holding member (an end surface frame 92) for holding the circuit board, and the holding member may have a notch (a notch 92n) through which a first wiring and a second wiring pass.

In this case, the first wiring and the second wiring are arranged to pass through the notch in the holding member. Thus, the first wiring and the second wiring are easily pulled out in one direction. As a result, the battery module becomes easier to assemble.

The battery module may further include a plurality of resistors (resistors R) connected between the electrodes of the battery cells, the circuit board may have first and second surfaces, the detector and the communication unit may be mounted on the first surface, and the plurality of resistors may be provided at a position different from a position on the second surface and corresponding to the detector and the communication unit.

In this case, the discharged state of each of the battery cells can be controlled by controlling the current flowing through the plurality of resistors. The resistor is provided at a position different from a position on the second surface different from the first surface on which the detector and the communication unit in the circuit board are mounted and corresponding to the detector and the communication unit. Thus, heat generated from the resistor can be efficiently dissipated. The heat generated from the resistor can be prevented from being transmitted to the detector and the communication unit. As a result, the detector and the communication unit can be prevented from malfunctioning and deteriorating by the heat.

### [Advantageous Effects of Invention]

According to the present invention, a voltage between terminals of a battery cell can be intensively managed without increasing the size of a battery module.

### [Brief Description of Drawings]

[FIG. 1] FIG. 1 is a block diagram illustrating a configuration of a battery system according to a first embodiment.
[FIG. 2] FIG. 2 is a block diagram illustrating a configuration of a printed circuit board illustrated in Fig. 1.
[FIG. 3] FIG. 3 is an external perspective view of a battery module.
[FIG. 4] FIG. 4 is a plan view of the battery module.
[FIG. 5] FIG. 5 is an end view of the battery module.
[FIG. 6] FIG. 6 is an external perspective view of bus bars.
[FIG. 7] FIG. 7 is an external perspective view illustrating a state where a plurality of bus bars and a plurality of PTC elements are attached to FPC boards.
[FIG. 8] FIG. 8 is a schematic plan view for illustrating connection between the bus bars and a detection circuit.
[FIG. 9] FIG. 9 is an enlarged plan view illustrating a voltage/current bus bar and the FPC board.
[FIG. 10] FIG. 10 is a schematic plan view illustrating an example of a configuration of the printed circuit board.
[FIG. 11] FIG. 11 is an external perspective view illustrating an arrangement of a wiring used to connect a communication circuit in the battery module.
[FIG. 12] FIG. 12 is a schematic plan view of an input/output harness used to connect the communication circuit in the battery module.
[FIG. 13] FIG. 13 is a schematic plan view illustrating an example of connection of the communication circuit in the battery module.
[FIG. 14] FIG. 14 is a schematic plan view illustrating an example of a detailed configuration of a battery system.
[FIG. 15] FIG. 15 is a diagram illustrating connection between a plurality of printed circuit boards and a battery ECU in a battery system according to a second embodiment.
[FIG. 16] FIG. 16 is a schematic plan view of an input/output harness used to connect a communication circuit in a battery module according to the second embodiment.
[FIG. 17] FIG. 17 is a schematic plan view illustrating an example of a detailed configuration of the battery system according to the second embodiment.
[FIG. 18] FIG. 18 is a schematic plan view of a printed circuit board provided in a battery module according to a third embodiment.
[FIG. 19] FIG. 19 is a schematic plan view of FPC boards connected to the printed circuit board illustrated in Fig. 18.
[FIG. 20] FIG. 20 is a schematic plan view of a printed circuit board provided in a battery module according to a fourth embodiment.
[FIG. 21] FIG. 21 is an external perspective view illustrating a battery module according to a fifth embodiment.
[FIG. 22] FIG. 22 is an external perspective view illustrating a battery module according to a sixth embodiment.
[FIG. 23] FIG. 23 is a side view on one side of the battery module illustrated in Fig. 22.
[FIG. 24] FIG. 24 is a side view on the other side of the battery module illustrated in Fig. 22.
[FIG. 25] FIG. 25 is a schematic plan view illustrating an example of a configuration of a printed circuit board according to the sixth embodiment.
[FIG. 26] FIG. 26 is a side view illustrating a state where a printed circuit board is attached to a battery block illustrated in Fig. 22.
[FIG. 27] FIG. 27 is an external perspective view of a battery module housed in a casing.
[FIG. 28] FIG. 28 is a schematic plan view illustrating an example of a detailed configuration of a battery system according to the sixth embodiment.
[FIG. 29] FIG. 29 is an external perspective view on one side of a battery module according to a seventh embodiment.
[FIG. 30] FIG. 30 is an external perspective view on the other side of the battery module illustrated in Fig. 29.
[FIG. 31] FIG. 31 is an external perspective view on one side of a battery module according to an eighth embodiment.
[FIG. 32] FIG. 32 is a side view on one side of a battery module according to a ninth embodiment.
[FIG. 33] FIG. 33 is a side view on the other side of the battery module illustrated in Fig. 32.
[FIG. 34] FIG. 34 is an external perspective view of the battery module according to the ninth embodiment.
[FIG. 35] FIG. 35 is a block diagram illustrating a configuration of an electric automobile including the battery system.

### [Description of Embodiments]

### [1] First Embodiment

A battery module according to a first embodiment and a battery system including the same will be described below while referring to the drawings. The battery module and the battery system according to the present embodiment are mounted on an electric vehicle (e.g., an electric automobile) using electric power as a driving source.

### (1) Configuration of Battery System

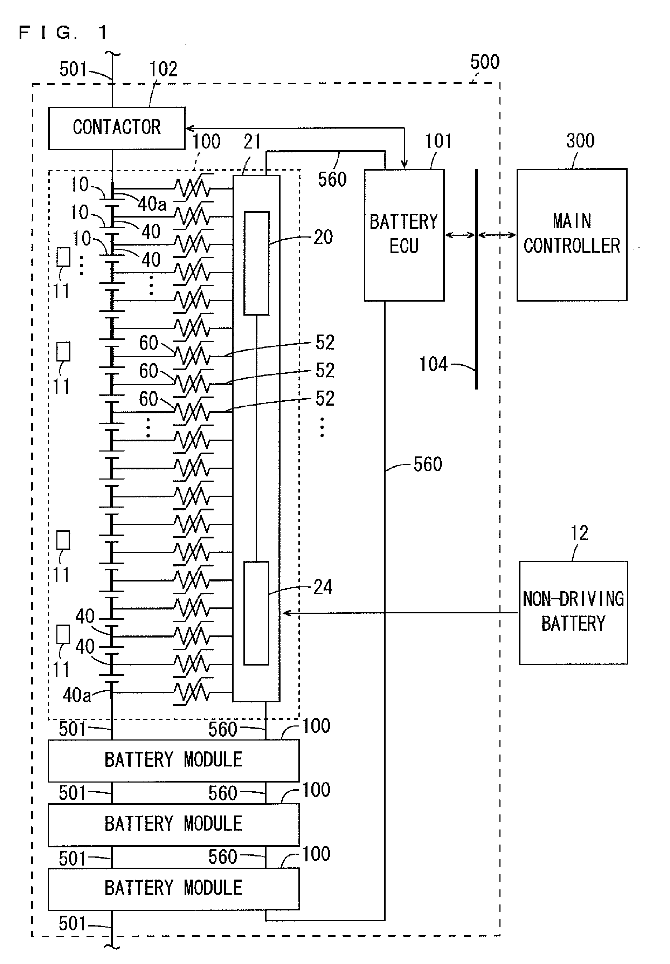

Fig. 1 is a block diagram illustrating a configuration of a battery system according to the first embodiment. As illustrated in Fig. 1, the battery system 500 includes a plurality of (four in this example) battery modules 100, a battery ECU 101, and a contactor 102, and is connected to a main controller 300 in an electric vehicle through a bus 104.

The plurality of battery modules 100 in the battery system 500 are connected to one another through power supply lines 501. Each of the battery modules 100 includes a plurality of (eighteen in this example) battery cells 10, a plurality of (four in this example) thermistors 11, and a rigid printed circuit board (hereinafter abbreviated as a printed circuit board) 21.

In each of the battery modules 100, the plurality of battery cells 10 are integrally arranged adjacent to one another, and are connected in series through a plurality of bus bars 40. Each of the battery cells 10 is a secondary battery such as a lithium-ion battery or a nickel metal hydride battery.

The battery cells 10 arranged at both ends of each of the battery modules 100 are connected to the power supply lines 501 through bus bars 40a, respectively. Thus, all the battery cells 10 in the plurality of battery modules 100 are connected in series in the battery system 500. The power supply lines 501 pulled out from the battery system 500 are connected to a load such as a motor of the electric vehicle. Details of the battery modules 100 will be described below.

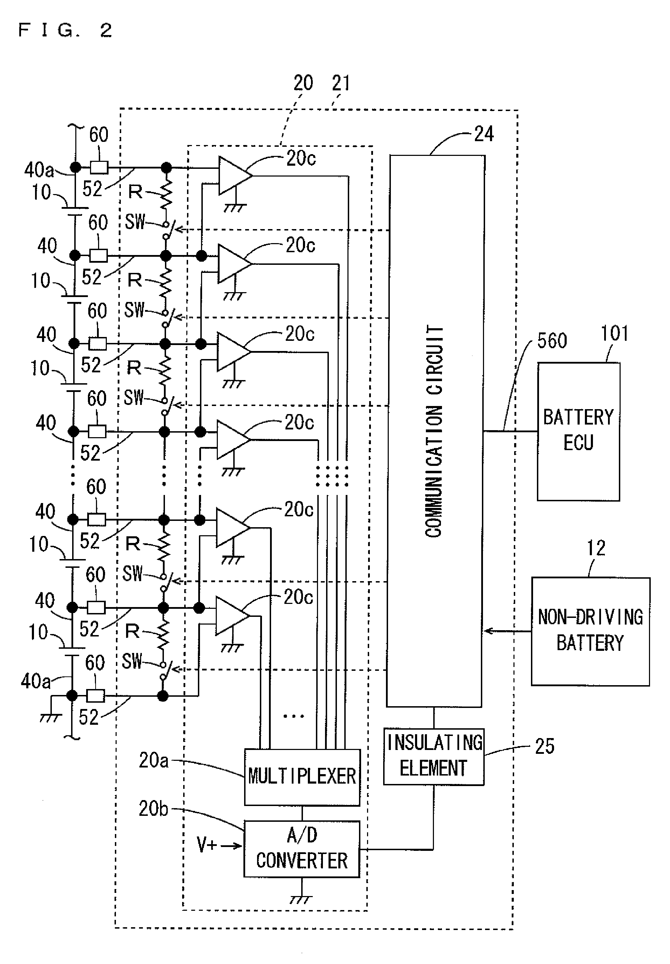

Fig. 2 is a block diagram illustrating a configuration of the print circuit board 21 illustrated in Fig. 1. The print circuit board 21 includes a detection circuit 20, a communication circuit 24, an insulating element 25, a plurality of resistors R, and a plurality of switching elements SW. The detection circuit 20 includes a multiplexer 20a, an A/D (Analog/Digital) converter 20b, and a plurality of differential amplifiers 20c. A configuration of the printed circuit board 21 will be described below with reference to Figs. 1 and 2.

The detection circuit 20 is composed of an ASIC (Application Specific Integrated Circuit), for example, and the plurality of battery cells 10 in the battery module 100 are used as a power source of the detection circuit 20. Each of the differential amplifiers 20c in the detection circuit 20 has two input terminals and an output terminal. Each of the differential amplifiers 20c differentially amplifies a voltage input to the two input terminals, and outputs the amplified voltage from the output terminal.

The two input terminals of each of the differential amplifiers 20c are electrically connected to the two adjacent bus bars 40 and 40a through conductor lines 52 and PTC (Positive Temperature Coefficient) elements 60, respectively.

The PTC element 60 has such resistance temperature characteristics as to have a resistance value rapidly increasing when its temperature exceeds a certain value. If a short occurs in the detection circuit 20 and the conductor line 52, for example, therefore, when the temperature of the PTC element 60 rises because of a current flowing through its short-circuited path, the resistance value of the PTC element 60 increases. Accordingly, a large current is inhibited from flowing through the short-circuited path including the PTC element 60.

The communication circuit 24 includes a CPU (Central Processing Unit), a step-down element, a memory, and an interface circuit, for example, and has a communication function and an operating function. A non-driving battery 12 of the electric vehicle is connected to the step-down element in the communication circuit 24. The step-down element reduces electric power from the non-driving battery 12, and feeds the reduced electric power to the CPU, the memory, and the interface circuit in the communication circuit 24. The non-driving battery 12 is thus used as a power source of the communication circuit 24. The non-driving battery 12 is a lead-acid battery in the present embodiment.

As illustrated in Fig. 1, the communication circuit 24 in each of the battery modules 100 and the battery ECU 101 are connected in series through a harness 560. Thus, the communication circuit 24 in each of the battery modules 100 can communicate with the other battery module 100 and the battery ECU 101.

A series circuit of the resistor R and the switching element SW is connected between the two adjacent bus bars 40 and 40a. The battery ECU 101 controls ON and OFF of the switching element SW via the communication circuit 24. The switching element SW is OFF in a normal state.

The detection circuit 20 and the communication circuit 24 are connected to enable communication with each other while being electrically insulated from each other by the insulating element 25. A voltage between the two adjacent bus bars 40 and 40a is differentially amplified by each of the differential amplifiers 20c. Output voltages from the differential amplifiers 20c correspond to terminal voltages of the battery cells 10, respectively. Terminal voltages output from the plurality of differential amplifiers 20c are fed to the multiplexer 20a. The multiplexer 20a sequentially outputs the terminal voltages fed from the plurality of differential amplifiers 20c to the A/D converter 20b. The A/D converter 20b converts the terminal voltages output from the multiplexer 20a into digital values, and feeds the digital values to the communication circuit 24 via the insulating element 25.

In the present embodiment, in at least one of the plurality of battery modules 100, the detection circuit 20 detects a voltage between two positions of the one bus bar 40, and the communication circuit 24 calculates a voltage detected by the detection circuit 20 and a current flowing in the plurality of battery cells 10 based on a resistor between the two positions of the bus bar 40. Details of the calculation of the current by the detection circuit 20 and the communication circuit 24 will be described below.

The communication circuit 24 is connected to the plurality of thermistors 11 illustrated in Fig. 1. Thus, the communication circuit 24 acquires the temperature of the battery module 100 based on output signals from the thermistors 11.

The communication circuit 24 in each of the battery modules 100 feeds the terminal voltages of the battery cells 10, the current flowing through the plurality of battery cells 10, and the temperature of the battery module 100 to the other battery module 100 or the battery ECU 101. The terminal voltage, the current, and the temperature are referred to as cell information.

The battery ECU 101 calculates a charged capacity of each of the battery cells 10 based on the cell information fed from the communication circuit 24 in each of the battery modules 100, for example, and controls charge and discharge of the battery module 100 based on the charged capacity. The battery ECU 101 detects an abnormality in each of the battery modules 100 based on the cell information fed from the communication circuit 24 in the battery module 100. The abnormality in the battery module 100 includes overdischarge, overcharge, or an abnormal temperature of the battery cell 10, for example.

While the battery ECU 101 calculates the charged capacity of each of the battery cells 10 and detects the overdischarge, overcharge, and abnormal temperature, for example, of the battery cell 10 in the present embodiment, the present invention is not limited to this. The communication circuit 24 in each of the battery modules 100 may calculate the charged capacity of each of the battery cells 10 and detect the overdischarge, overcharge, and abnormal temperature, for example, of the battery cell 10, and may feed the result to the battery ECU 101.

Referring to Fig. 1 again, the contactor 102 is inserted in the power supply line 501 connected to the battery module 100 at one end of the battery system 500. When detecting the abnormality in the battery module 100, the battery ECU 101 turns off the contactor 102. Since the current does not flow through each of the battery modules 100 when the abnormality occurs, the battery module 100 is prevented from being abnormally heated.

The battery ECU 101 is connected to the main controller 300 through the bus 104. The charged capacity of each of the battery modules 100 (the charged capacities of the battery cells 10) is fed from the battery ECU 101 to the main controller 300. The main controller 300 controls power of the electric vehicle (e.g., a rotational speed of the motor) based on the charged capacity. When the charged capacity of each of the battery modules 100 decreases, the main controller 300 controls a power generating system, not illustrated, connected to the power supply line 501, to charge the battery module 100.

In the present embodiment, the power generating system is a motor connected to the above-mentioned power supply line 501, for example. In this case, the motor converts electric power supplied from the battery system 500 into mechanical power for driving drive wheels, not illustrated, at the time of acceleration of the electric vehicle. The motor generates regenerated electric power at the time of deceleration of the electric vehicle. The regenerated electric power charges each of the battery modules 100.

### (2) Details of Battery Module

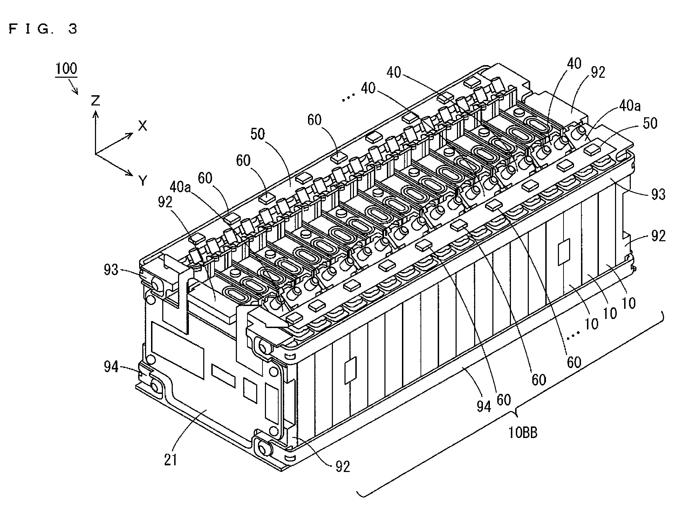

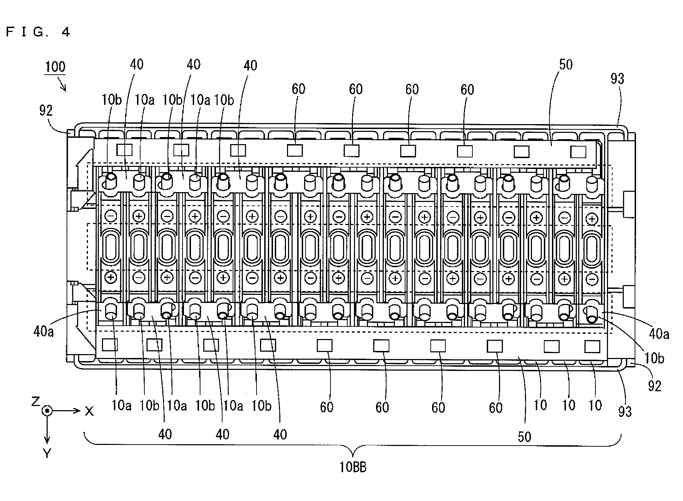

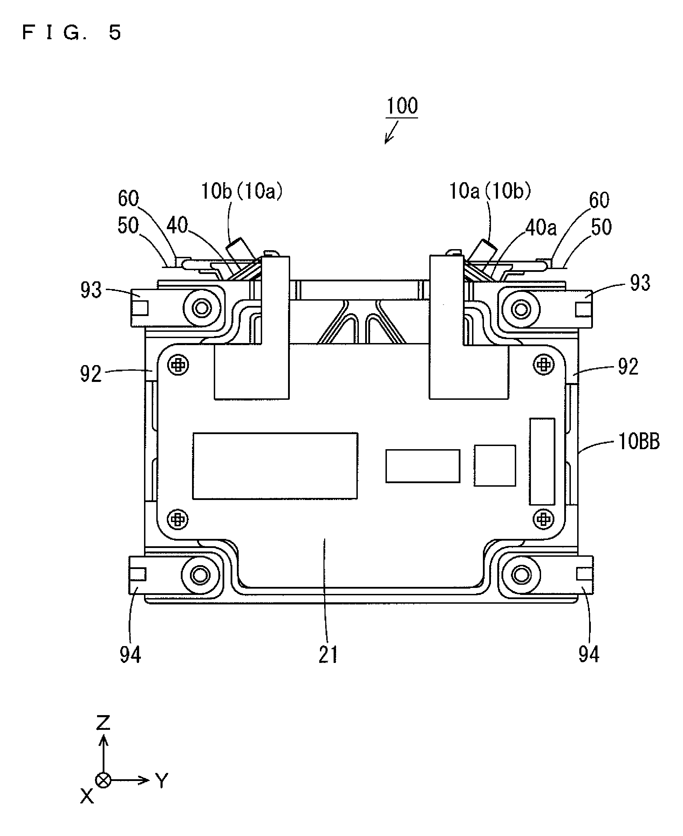

Details of the battery module 100 will be described. Fig. 3 is an external perspective view of the battery module 100, Fig. 4 is a plan view of the battery module 100, and Fig. 5 is an end view of the battery module 100.

In Figs. 3 to 5, Figs. 7 to 9, and Fig. 11, described below, three directions that are perpendicular to one another are defined as an X-direction, a Y-direction, and a Z-direction, as indicated by arrows X, Y, and Z, respectively. In this example, the X-direction and the Y-direction are parallel to a horizontal plane, and the Z-direction is perpendicular to the horizontal plane. An upward direction is a direction in which the arrow Z points.

As illustrated in Figs. 3 to 5, the plurality of battery cells 10 each having a flat and substantially rectangular parallelepiped shape are arranged to line up in the X-direction in the battery module 100. In this state, the plurality of battery cells 10 are integrally fixed by a pair of end surface frames 92, a pair of upper end frames 93, and a pair of lower end frames 94. The plurality of battery cells 10, the pair of end surface frames 92, the pair of upper end frames 93, and the pair of lower end frames 94 form a battery block 10BB having a substantially rectangular parallelepiped shape.

The battery block 10BB has an upper surface that is parallel to an XY plane. The battery block 10BB has one end surface and the other end surface that are parallel to a YZ plane. Further, the battery block 10BB has one side surface and the other side surface that are parallel to an XZ plane.

Each of the pair of end surface frames 92 has a substantially plate shape, and is arranged parallel to the YZ plane. The pair of upper end frames 93 and the pair of lower end frames 94 are arranged to extend in the X-direction.

Connection portions for connecting the pair of upper end frames 93 and the pair of lower end frames 94 are formed at four corners of each of the pair of end surface frames 92. The pair of upper end frames 93 is attached to the upper connection portions of the pair of end surface frames 92, and the pair of lower end frames 94 is attached to the lower connection portions of the pair of end surface frames 92 while the plurality of battery cells 10 are arranged between the pair of end surface frames 92. Accordingly, the plurality of battery cells 10 are integrally fixed while being arranged to line up in the X-direction.

The printed circuit board 21 is attached to an outer surface of the one end surface frame 92 at a spacing.

The battery cells 10 each have a plus electrode 10a and a minus electrode 10b arranged on its upper surface portion to line up in the Y-direction. Each of the electrodes 10a and 10b is provided at an angle to protrude upward (see Fig. 5).

In the following description, the battery cell 10 adjacent to the end surface frame 92 to which the printed circuit board 21 is not attached to the battery cell 10 adjacent to the end surface frame 92 to which the printed circuit board 21 is attached are referred to as a first battery cell 10 to an eighteenth battery cell 10.

In the battery module 100, the battery cells 10 are arranged so that a positional relationship between the plus electrode 10a and the minus electrode 10b in one of the adjacent battery cells 10 in the Y-direction is opposite to that in the other battery cell 10, as illustrated in Fig. 4.

Thus, in the two adjacent battery cells 10, the plus electrode 10a of the one battery cell 10 is in close proximity to the minus electrode 10b of the other battery cell 10, and the minus electrode 10b of the one battery cel1 10 is in close proximity to the plus electrode 10a of the other battery cell 10. In this state, the bus bar 40 is attached to the two electrodes being in close proximity to each other. Thus, the plurality of battery cells 10 are connected in series.

More specifically, the common bus bar 40 is attached to the plus electrode 10a of the first battery cell 10 and the minus electrode 10b of the second battery cell 10. The common bus bar 40 is attached to the plus electrode 10a of the second battery cell 10 and the minus electrode 10b of the third battery cell 10. Similarly, the common bus bar 40 is attached to the plus electrode 10a of each of the odd numbered battery cells 10 and the minus electrode 10b of each of the even numbered battery cells 10 adjacent thereto. The common bus bar 40 is attached to the plus electrode 10a of each of the even numbered battery cells 10 and the minus electrode 10b of each of the odd numbered battery cells 10 adjacent thereto.

The bus bar 40a for connecting the power supply line 501 (see Fig. 1) from the exterior is attached to each of the minus electrode 10b of the first battery cell 10 and the plus electrode 10a of the eighteenth battery cell 10.

A long-sized flexible printed circuit board (hereinafter abbreviated as an FPC board) 50 extending in the X-direction is connected in common to the plurality of bus bars 40 on the one end side of the plurality of battery cells 10 in the Y-direction. Similarly, a long-sized FPC board 50 extending in the X-direction is connected in common to the plurality of bus bars 40 and 40a on the other end side of the plurality of battery cells 10 in the Y-direction.

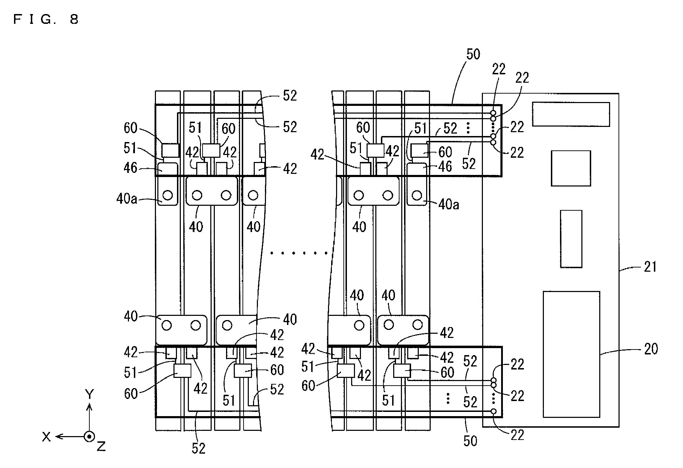

The FPC board 50 mainly has a configuration in which a plurality of conductor lines 51 and 52 (see Fig. 8, described below) are formed on an insulating layer, and has bending characteristics and flexibility. Examples of a material for the insulating layer constituting the FPC board 50 include polyimide, and examples of a material for the conductor lines 51 and 52 (see Fig. 8, described below) include copper. PTC elements 60 are arranged to be in close proximity to the bus bars 40 and 40a, respectively, on the FPC boards 50.

Each of the FPC boards 50 is bent inward at a right angle and further bent downward at an upper end portion of the end surface frame 92 (the end surface frame 92 to which the printed circuit board 21 is attached), and is connected to the printed circuit board 21.

### (3) Configurations of Bus Bars and FPC Boards

Details of configurations of the bus bars 40 and 40a and the FPC boards 50 will be described below. The bus bar 40 for connecting the plus electrode 10a and the minus electrode 10b of the two adjacent battery cells 10 is referred to as the bus bar for two electrodes 40, and the bus bar 40a for connecting the plus electrode 10a or the minus electrode 10b of the one battery cell 10 and the power supply line 501 is referred to as the bus bar for one electrode 40a.

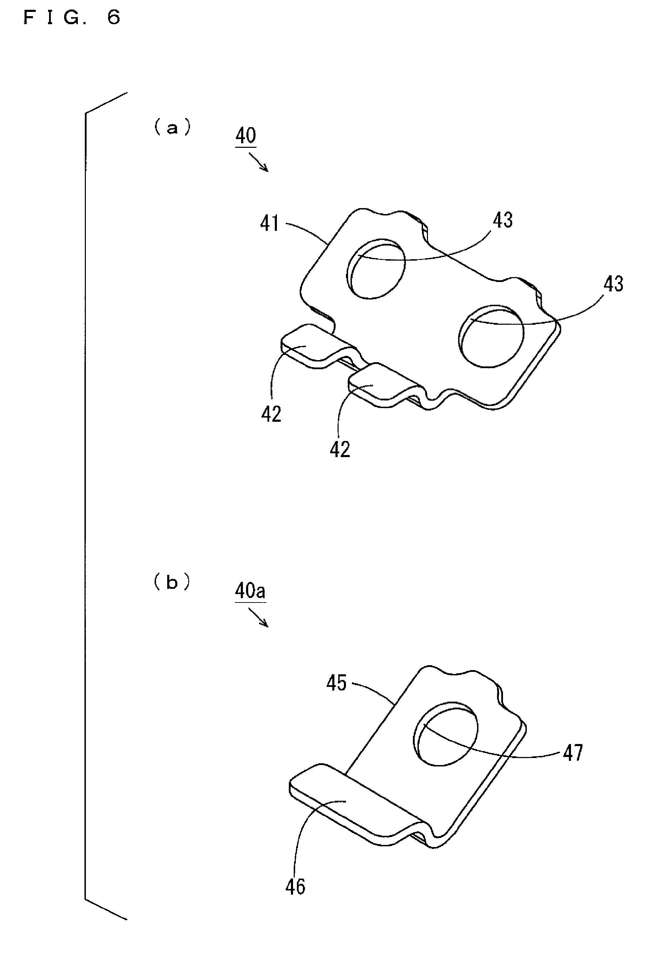

Fig. 6 (a) is an external perspective view of the bus bar for two electrodes 40, and Fig. 6 (b) is an external perspective view of the bus bar for one electrode 40a.

As illustrated in Fig. 6 (a), the bus bar for two electrodes 40 includes a base portion 41 having a substantially rectangular shape and a pair of attachment portions 42 that is bent and extends from one side of the base portion 41 toward its one surface side. A pair of electrode connection holes 43 is formed in the base portion 41.

As illustrated in Fig. 6 (b), the bus bar for one electrode 40a includes a base portion 45 having a substantially square shape and an attachment portion 46 that is bent and extends from one side of the base portion 45 toward its one surface side. An electrode connection hole 47 is formed in the base portion 45.

In the present embodiment, the bus bars 40 and 40a are each composed of tough pitch copper having a nickel-plated surface, for example.

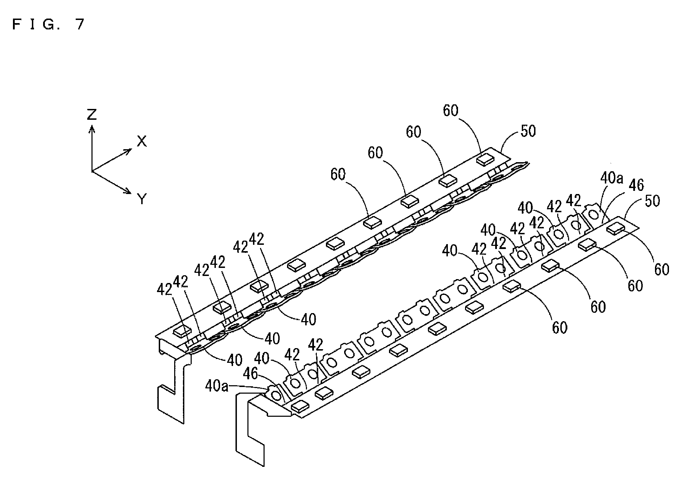

Fig. 7 is an external perspective view illustrating a state where the plurality of bus bars 40 and 40a and the plurality of PTC elements 60 are attached to the FPC boards 50. As illustrated in Fig. 7, attachment portions 42 and 46 of the plurality of bus bars 40 and 40a are attached to the two FPC boards 50 at spacings in the X-direction. The plurality of PTC elements 60 are each attached to the two FPC boards 50 at the same spacings as spacings between the plurality of bus bars 40 and 40a.

When the battery module 100 is manufactured, the two FPC boards 50 having the plurality of bus bars 40 and 40a and the plurality of PTC elements 60 attached thereto in the foregoing manner are each attached on the plurality of battery cells 10 that are integrally fixed by the end surface frames 92 (see Fig. 3), the upper end frames 93 (see Fig. 3), and the lower end frames 94 (see Fig. 3).

During the attachment, the plus electrode 10a and the minus electrode 10b of the adjacent battery cells 10 are fitted in the electrode connection holes 43 formed in each of the bus bars 40, and the plus electrode 10a of the eighteenth battery cell 10 and the minus electrode 10b of the first battery cell 10 are fitted in the electrode connection holes 47 formed in the bus bars 40a, respectively. A male thread is formed in each of the plus electrode 10a and the minus electrode 10b. With each of the bus bars 40 fitted with the plus electrode 10a and minus electrode 10b of the adjacent battery cells 10, and the bus bars 40a fitted with the plus electrode 10a and the minus electrode 10b, respectively, nuts (not illustrated) are screwed in the male threads in the plus electrodes 10a and the minus electrodes 10b, respectively.

In this manner, the plurality of bus bars 40 and 40a are attached to the plurality of battery cells 10 while holding the FPC boards 50 in a substantially horizontal attitude.

### (4) Connection between Bus Bars and Detection Circuit

Connection between the bus bars 40 and 40a and the detection circuit 20 will be described below. Fig. 8 is a schematic plan view for illustrating the connection between the bus bars 40 and 40a and the detection circuit 20.

As illustrated in Fig. 8, each of the FPC boards 50 is provided with the plurality of conductor lines 51 and the plurality of conductor lines 52 so that the conductor line 51 and the conductor line 52 correspond to each of the bus bars 40 and 40a. The conductor lines 51 are provided to extend parallel to the Y-direction between the attachment portions 42 and 46 of the bus bars 40 and 40a and the PTC elements 60 arranged in the vicinity of the bus bars 40, respectively. Each of the conductor lines 52 is provided to extend parallel to the X-direction between the PTC element 60 and one end of the FPC board 50.

One end of each of the conductor lines 51 is provided to be exposed on a lower surface of the FPC board 50. The one ends of the conductor lines 51 exposed on the lower surface are electrically connected to the attachment portions 42 and 46 of the bus bars 40 and 40a, respectively, by soldering or welding, for example. Accordingly, the FPC board 50 is fixed to each of the bus bars 40 and 40a.

The other end of the conductor line 51 and one end of the conductor line 52 are provided to be exposed on an upper surface of the FPC board 50. A pair of terminals (not illustrated) of the PTC element 60 is connected to the other end of the conductor line 51 and the one end of the conductor line 52 by soldering, for example.

Each of the PTC elements 60 is preferably arranged in a region between both ends in the X-direction of the corresponding bus bar 40 or 40a. When stress is applied to the FPC boards 50, a region of the FPC boards 50 between the adjacent bus bars 40 or 40 and 40a is easily deflected. However, a region of the FPC boards 50 between both the ends of each of the bus bars 40 and 40a is kept relatively flat because it is fixed to the bus bar 40 and 40a. Therefore, each of the PTC elements 60 is arranged within the region of the FPC boards 50 between both the ends of each of the bus bars 40 and 40a so that connectivity between the PTC element 60 and the conductor lines 51 and 52 is sufficiently ensured. The effect of the deflection of the FPC boards 50 on each of the PTC elements 60 (e.g., a change in a resistance value of the PTC element 60) is suppressed.

A plurality of connection terminals 22, respectively corresponding to the plurality of conductor lines 52, of the FPC boards 50 are provided in the printed circuit board 21. The plurality of connection terminals 22 and the detection circuit 20 are electrically connected to each other on the printed circuit board 21. The other ends of the conductor lines 52 of the FPC boards 50 are connected to the corresponding connection terminals 22 by soldering or welding, for example. The printed circuit board 21 and the FPC boards 50 may be connected by not only soldering or welding but also using a connector.

In this manner, each of the bus bars 40 and 40a is electrically connected to the detection circuit 20 through the PTC element 60. Thus, the terminal voltage of each of the battery cells 10 is detected.

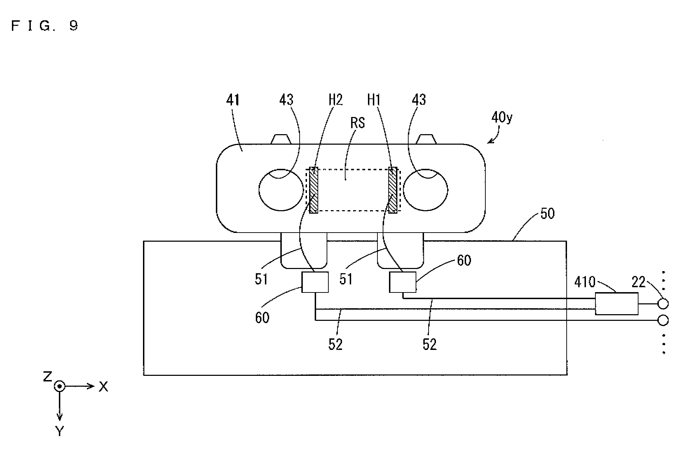

One of the plurality of bus bars 40 in at least one of the battery modules 100 is used as a shunt resistor for current detection. The bus bar 40 used as the shunt resistor is referred to as a voltage/current bus bar 40y. Fig. 9 is an enlarged plan view illustrating the voltage/current bus bar 40y and the FPC board 50. As illustrated in Fig. 9, the printed circuit board 21 further includes an amplification circuit 410.

A pair of solder traces H1 and H2 is formed parallel to each other at a predetermined spacing on the base portion 41 of the voltage/current bus bar 40y. The solder trace H1 is arranged, between the two electrode connection holes 43, in the vicinity of one of the electrode connection holes 43, and the solder trace H2 is arranged, between the electrode connection holes 43, in the vicinity of the other electrode connection hole 43. A resistor formed between the solder traces H1 and H2 in the voltage/current bus bar 40y is referred to as a shunt resistor RS for current detection.

The solder trace H1 of the voltage/current bus bar 40y is connected to one input terminal of the amplification circuit 410 on the printed circuit board 21 through the conductor line 51, the PTC element 60, and the conductor line 52. Similarly, the solder trace H2 of the voltage/current bus bar 40y is connected to the other input terminal of the amplification circuit 410 through the conductor line 51, the PTC element 60, and the conductor line 52. Thus, the detection circuit 20 detects a voltage between the solder traces H1 and H2 based on an output voltage of the amplification circuit 410. The voltage detected by the detection circuit 20 is fed to the communication circuit 24.

In the present embodiment, the memory included in the communication circuit 24 previously stores a value of the shunt resistor RS between the solder traces H1 and H2 in the voltage/current bus bar 40y. The communication circuit 24 divides a voltage between the solder traces H1 and H2 by the value of the shunt resistor RS stored in the memory, to calculate a value of a current flowing through the voltage/current bus bar 40y. Thus, a value of a current flowing through the battery module 100 is detected.

### (5) Example of Configuration of Printed Circuit Board

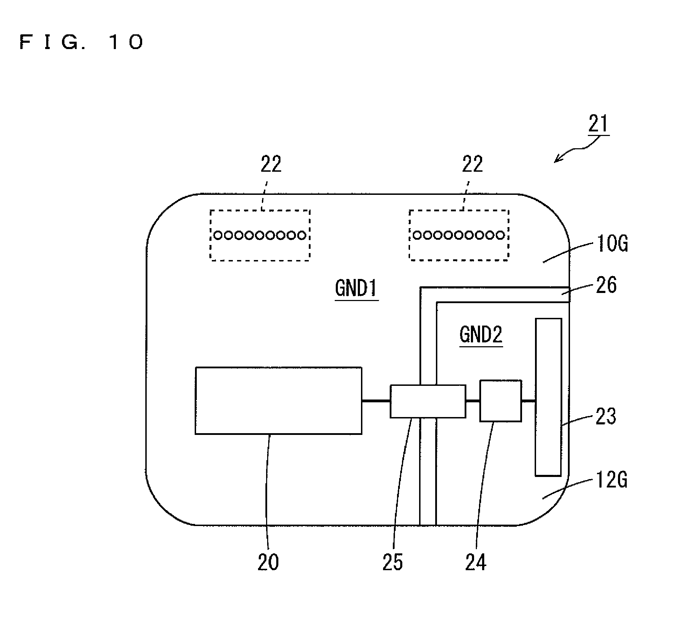

An example of a configuration of the printed circuit board 21 will be described below. Fig. 10 is a schematic plan view illustrating an example of the configuration of the printed circuit board 21.

As illustrated in Fig. 10, the printed circuit board 21 has a substantially rectangular shape. The detection circuit 20, the communication circuit 24, and the insulating element 25 are mounted on the printed circuit board 21. A plurality of connection terminals 22 and a connector 23 are formed on the printed circuit board 21. Illustration of the resistors R and the switching elements SW illustrated in Fig. 2 is omitted.

The printed circuit board 21 includes a first mounting region 10G, a second mounting region 12G, and a strip-shaped insulating region 26.

The second mounting region 12G is formed at one corner of the printed circuit board 21. The insulating region 26 is formed to extend along the second mounting region 12G. The first mounting region 10G is formed in the remaining part of the printed circuit board 21. The first mounting region 10G and the second mounting region 12G are separated from each other by the insulating region 26. Thus, the first mounting region 10G and the second mounting region 12G are electrically insulated from each other by the insulating region 26.

The detection circuit 20 is mounted while the plurality of connection terminals 22 are formed in the first mounting region 10G. The detection circuit 20 and the plurality of connection terminals 22 are electrically connected to each other through connecting lines, respectively, on the printed circuit board 21. The plurality of battery cells 10 (see Fig. 1) in the battery module 100 are connected to the detection circuit 20 as a power source of the detection circuit 20. A ground pattern GND1 is formed in the first mounting region 10G not including a mounting region of the detection circuit 20, formation regions of the connection terminals 22, and formation regions of the connecting lines. The ground pattern GND1 is held at a reference potential of the battery module 100.

The communication circuit 24 is mounted while the connector 23 is formed in the second mounting region 12G, and the communication circuit 24 and the connector 23 are electrically connected to each other through a plurality of connecting lines on the printed circuit board 21. The non-driving battery 12 (see Fig. 1) included in the electric vehicle is connected to the communication circuit 24 as a power source of the communication circuit 24. A ground pattern GND2 is formed in the second mounting region 12G not including a mounting region of the communication circuit 24, a formation region of the connector 23, and formation regions of the plurality of connecting lines. The ground pattern GND2 is held at a reference potential of the non-driving battery 12.

The insulating element 25 is mounted over the insulating region 26. The insulating element 25 electrically insulates the ground pattern GND1 and the ground pattern GND2 from each other while transmitting a signal between the detection circuit 20 and the communication circuit 24. A digital isolator or a photocoupler, for example, can be used as the insulating element 25. In the present embodiment, the digital isolator is used as the insulating element 25.

Thus, the detection circuit 20 and the communication circuit 24 are connected to enable communication with each other while being electrically insulated from each other by the insulating element 25. Thus, the plurality of battery cells 10 can be used as the power source of the detection circuit 20, and the non-driving battery 12 (see Fig. 1) can be used as the power source of the communication circuit 24. As a result, each of the detection circuit 20 and the communication circuit 24 can be independently and stably operated.

### (6) Connection of Communication Circuit

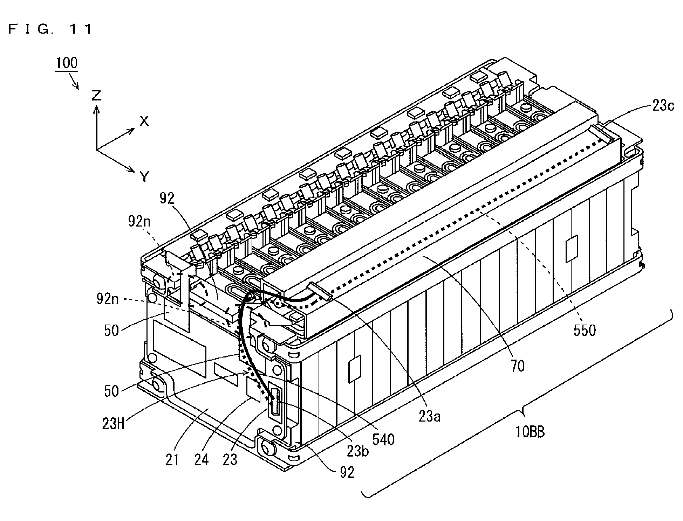

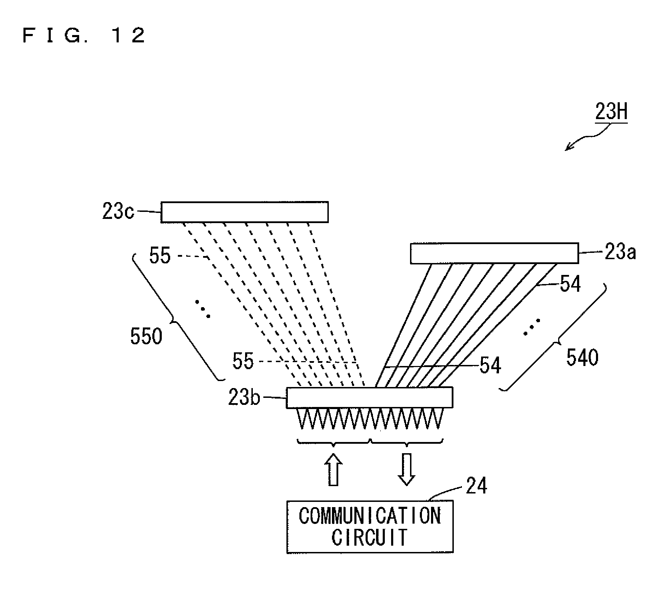

Connection of the communication circuit 24 will be described below. Fig. 11 is an external perspective view illustrating an arrangement of a wiring used to connect the communication circuit 24 in the battery module 100. Fig. 12 is a schematic plan view of an input/output harness used to connect the communication circuit 24 in the battery module 100.

As illustrated in Fig. 11, the printed circuit board 21 illustrated in Fig. 10 is attached to an outer surface of the one end surface frame 92 in the battery module 100 at a spacing. As described above, the connector 23 in the printed circuit board 21 is connected to the communication circuit 24.

The connector 23 is connected to a connector 23 in the other battery module 100 so that the communication circuit 24 in the battery module 100 illustrated in Fig. 11 can be connected to a communication circuit 24 in the other battery module 100. Thus, the communication circuit 24 in the battery module 100 illustrated in Fig. 11 can transmit cell information of the battery module 100 to the communication circuit 24 in the other battery module 100 while receiving cell information from the other battery module 100.

An input/output harness 23H illustrated in Fig. 12 is connected to the connector 23 in each of the battery modules 100 to connect the connector 23 in the battery module 100 to the connector 23 in the other battery module 100. As illustrated in Figs. 11 and 12, the input/output harness 23H includes an input connector 23a, a relay connector 23b, an output connector 23c, and harnesses 540 and 550.

The input connector 23a has a plurality of input terminals for signal receiving. The relay connector 23b has a plurality of input terminals for signal receiving and a plurality of output terminals for signal transmission. The output connector 23c has a plurality of output terminals for signal transmission.

The harness 540 connects the plurality of input terminals of the input connector 23a and the plurality of input terminals of the relay connector 23b. The harness 550 connects the plurality of output terminals of the relay connector 23b and the plurality of output terminals of the output connector 23c. In Fig. 11, the harnesses 540 and 550 are indicated by a solid line and a dotted line, respectively. In Fig. 12, a plurality of conductor lines 54 and a plurality of conductor lines 55 constituting the harnesses 540 and 550 are indicated by a plurality of solid lines and a plurality of dotted lines, respectively.

Thus, the relay connector 23b is connected to the connector 23 on the printed circuit board 21, and each of the input connector 23a and the output connector 23c is connected to the other battery module 100 so that the cell information received from the other battery module 100 is input to the communication circuit 24 via the input connector 23a and the relay connector 23b. The cell information output from the communication circuit 24 is transmitted to the other battery module 100 via the relay connector 23b and the output connector 23c.

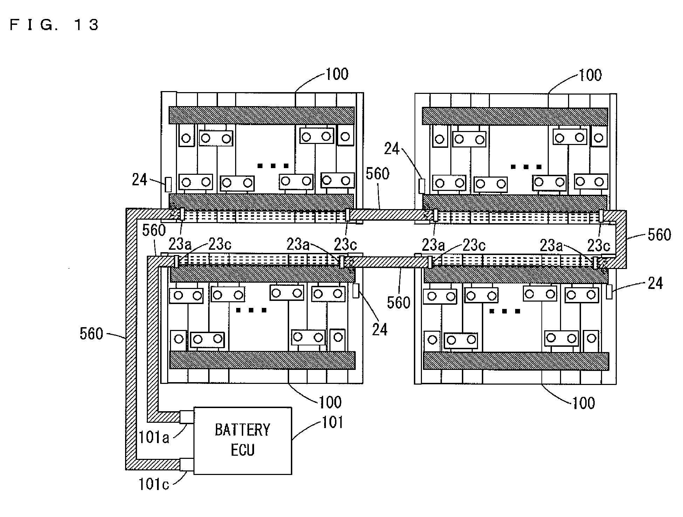

A harness 560 (see Fig. 13) is used for connection between the input connector 23a and the other battery module 100 and connection between the output connector 23c and the other battery module 100.

As described above, the relay connector 23b is connected to the connector 23 in the printed circuit board 21. In this state, both the input connector 23a and the output connector 23c in the input/output harness 23H are arranged on an upper surface of the battery module 100.

A terminal cover 70 is provided on an upper surface of the battery block 10BB illustrated in Fig. 11 to cover the electrodes 10a and 10b on one side of the battery cells 10 (see Fig. 3) and the FPC board 50 (see Fig. 3) on the one side to arrange the input connector 23a and the output connector 23c. The input connector 23a and the output connector 23c are fixed to the upper surface of the terminal cover 70 with an adhesive or the like.

Thus, the harnesses 540 and 550 for connecting the communication circuit 24 and the other battery module 100 are pulled out upward from the printed circuit board 21. The conductor lines 52 (see Fig. 8) for respectively connecting the detection circuit 20 and the plurality of bus bars 40 and 40a illustrated in Fig. 1 are pulled out upward from the printed circuit board 21 with the FPC boards 50 connected to the printed circuit board 21, as described above.

In the battery module 100 according to the present embodiment, the harnesses 540 and 550 for communication and the conductor lines 52 for voltage detection are pulled out in the same direction (Z-direction) from the printed circuit board 21. Thus, the conductor lines 52 and the harnesses 540 and 550 are arranged to concentrate in one direction of the printed circuit board 21. Therefore, the printed circuit board 21 becomes easy to handle, and the battery module 100 becomes easy to assemble. Since the conductor lines 52 and the harnesses 540 and 550 do not exist around the printed circuit board 21 excluding the one direction, heat dissipation characteristics of the detection circuit 20 and the communication circuit 24 are improved.

As illustrated in Fig. 11, a notch 92n for passing the conductor lines 52 and the harnesses 540 and 550 is formed at an upper end of the end surface frame 92 for holding the printed circuit board 21. Thus, the conductor lines 52 and the harnesses 540 and 550 can be easily pulled out upward by being passed through the notch 92n from the printed circuit board 21. In this case, the battery module 100 becomes easier to assemble.

Fig. 13 is a schematic plan view illustrating an example of connection of the communication circuit 24 in the battery module 100.

As illustrated in Fig. 13, in the present embodiment, communication circuits 24 in the four battery modules 100 (four in this example)and the battery ECU 101 are connected in series. In Fig. 13, illustration of the power supply lines 501 (see Fig. 1) for connecting the battery modules 100 is omitted.

The battery ECU 101 includes an input connector 101a and an output connector 101c. In the following description, the battery module 100 connected to the output connector 101c in the battery ECU 101 to the battery module 100 connected to the input connector 101a in the battery ECU 101 are referred to as first to fourth battery modules in this order.

The harness 560 connects the output connector 101c in the battery ECU 101 and the input connector 23a in the first battery module 100. The harness 560 connects the output connector 23c in the first battery module 100 and the input connector 23a in the second battery module 100. Similarly, the harness 560 connects the output connector 23c in the second battery module 100 and the input connector 23a in the third battery module 100. The harness 560 connects the output connector 23c in the third battery module 100 and the input connector 23a in the fourth battery module 100. The harness 560 connects the output connector 23c in the fourth battery module 100 and the input connector 101a in the battery ECU 101.

The four battery modules 100 and the battery ECU 101 are connected to each other, as described above, so that cell information of the first battery module 100 is transmitted to the input connector 23a in the second battery module 100 via the output connector 23c and the harness 560.

In the second battery module 100, the cell information received by the input connector 23a is fed to the communication circuit 24 via the harness 540 (Fig. 12), the relay connector 23b (Fig. 12), and the connector 23 (Fig. 10). The cell information output from the communication circuit 24 is fed to the input connector 23a in the second battery module 100 via the connector 23, the relay connector 23b (Fig. 12), the harness 550 (Fig. 12), the output connector 23c, and the harness 560.

The cell information is communicated among the second to fourth battery modules 100 in the above-mentioned manner. In the fourth battery module 100, the cell information output from the communication circuit 24 is transmitted to the input connector 101a in the battery ECU 101 via the connector 23, the relay connector 23b (Fig. 12), the harness 550 (Fig. 12), the output connector 23c, and the harness 560.

The battery ECU 101 can thus intensively manage the cell information of the plurality of battery modules 100. In this case, the battery ECU 101 is connected to two of the battery modules 100 so that a wiring for transmitting the cell information of the plurality of battery modules 100 to the battery ECU 101 is simplified.

As described above, according to the present embodiment, the communication circuits 24 in the plurality of battery modules 100 and the battery ECU 101 are connected in series, and the communication circuit 24 in each of the battery modules 100 transmits the detected cell information to the communication circuit 24 in the adjacent battery module 100 or the battery ECU 101 while receiving the cell information from the communication circuit 24 in the adjacent battery module 100 or the battery ECU 101, the present invention is not limited to this.

For example, the communication circuit 24 in each of the battery modules 100 may be connected to the battery ECU 101 through a bus. In this case, the communication circuit 24 in each of the battery modules 100 transmits the detected cell information to the battery ECU 101 via the bus. Therefore, the communication circuit 24 need not have a communication function for receiving cell information.

The communication circuits 24 in the battery modules 100 may individually be connected in parallel to the battery ECU 101 through harnesses, respectively. In this case, the communication circuit 24 in each of the battery modules 100 transmits the detected cell information to the battery ECU 101 via the harness. Therefore, the communication circuit 24 need not have a communication circuit for receiving cell information.

### (7) Equalization of Voltages of Battery Cells

The battery ECU 101 calculates, from cell information of each of the battery cells 10, a charged capacity of the battery cell 100. When detecting that the charged capacity of any one of the battery cells 10 is larger than those of the other battery cells 10, the battery ECU 101 turns on the switching element SW (see Fig. 2) connected to the battery cell 10 having the large charged capacity. Thus, charges charged in the battery cell 10 are discharged via the resistor R (see Fig. 2). When the charged capacity of the battery cell 10 decreases to be substantially equal to each of the charged capacities of the other battery cells 10, the battery ECU 101 turns off the switching element SW connected to the battery cell 10. Thus, the charged capacities of all the battery cells 10 are kept substantially equal. This prevents some of the battery cells 10 from being excessively charged or discharged. As a result, the battery cells 10 can be prevented from deteriorating.

While in the present embodiment, the battery ECU 101 calculates the charged capacity of each of the battery cells 10, detects the battery cell 10 having the large charged capacity, and controls the switching elements SW, the present invention is not limited to this. The communication circuit 24 in each of the battery modules 100 may calculate the charged capacity of each of the battery cells 10, detect the battery cell 10 having the large charged capacity, and control the switching elements SW.

### (8) Example of Detailed Configuration of Battery System

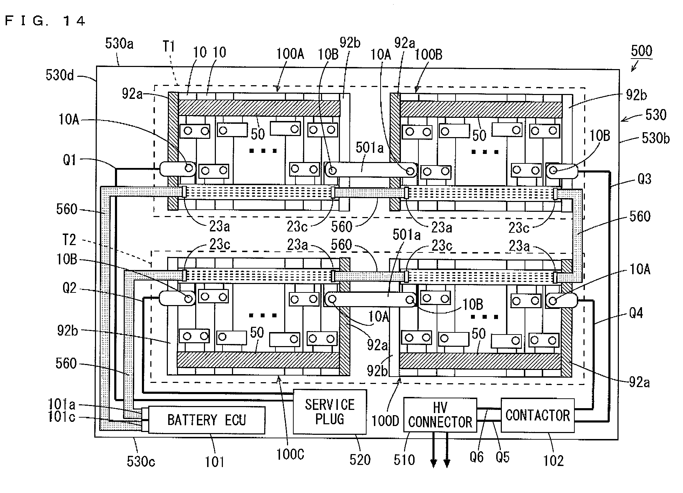

Fig. 14 is a schematic plan view illustrating one example of a detailed configuration of a battery system 500. As illustrated in Fig. 14, the battery system 500 includes four battery modules 100, a battery ECU 101, a contactor 102, an HV (High Voltage) connector 510, and a service plug 530.

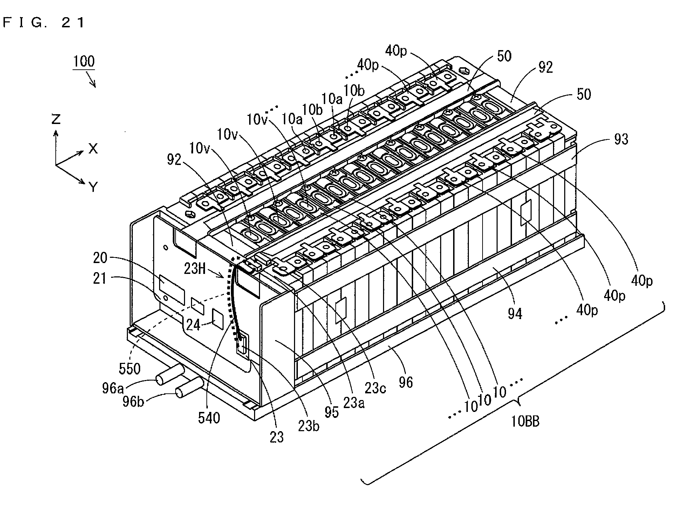

In the following description, the four battery modules 100 are referred to as battery modules 100A, 100B, 100C, and 100D, respectively. In pairs of end surface frames 92 provided in the battery modules 100A, 100B, 100C, 100D, respectively, the end surface frame 92 to which the printed circuit board 21 (see Fig. 10) is attached is referred to as an end surface frame 92a, and the end surface frame 92 to which the printed circuit board 21 is not attached is referred to as an end surface frame 92b. In Fig. 21, the end surface frame 92a is hatched.

The battery modules 100A to 100D, the battery ECU 101, the contactor 102, the HV connector 510, and the service plug 520 are housed in a box-shaped casing 530.

The casing 530 has side walls 530a, 530b, 530c, and 530d. The side walls 530a and 530c are parallel to each other, and the side walls 530b and 530d are parallel to each other and perpendicular to the side walls 530a and 530c.

Within the casing 530, the battery modules 100A and 100B are arranged to line up at a predetermined spacing. In this case, the battery modules 100A and 100B are arranged so that the end surface frame 92b of the battery module 100A and the end surface frame 92a of the battery module 100B face each other. The battery modules 100C and 100D are arranged to line up at a predetermined spacing. In this case, the battery modules 100A and 100B are arranged so that the end surface frame 92a of the battery module 100C and the end surface frame 92b of the battery module 100D face each other. Hereinafter, the battery modules 100A and 100B arranged to line up are referred to as a module row T1, and the battery modules 100C and 100D arranged to line up are referred to as a module row T2.

Within the casing 530, the module row T1 is arranged along the side wall 530a, and the module row T2 is arranged parallel to the module row T1. The end surface frame 92a of the battery module 100A in the module row T1 is directed to the side wall 530d, and the end surface frame 92b of the battery module 100B in the module row T1 is directed to the side wall 530b. The end surface frame 92b of the battery module 100C in the module row T2 is directed to the side wall 530d, and the end surface frame 92a of the battery module 100D in the module row T2 is directed to the side wall 530b.

The battery ECU 101, the service plug 520, the HV connector 510, and the contactor 102 are arranged to line up in this order from the side wall 530d to the side wall 530b in a region between the module row T2 and the side wall 530c.

In each of the battery modules 100A to 100D, a potential of the plus electrode 10a (see Fig. 4) of the battery cell 10 adjacent to the end surface frame 92a is the highest, and a potential of the minus electrode 10b (see Fig. 4) of the battery cell 10 adjacent to the end surface frame 92b is the lowest. Hereinafter, the plus electrode 10a having the highest potential in each of the battery modules 100A to 100D is referred to as a high potential electrode 10A, and the minus electrode 10b having the lowest potential in each of the battery modules 100A to 100D is referred to as a low potential electrode 10B.

The low potential electrode 10B of the battery module 100A and the high potential electrode 10A of the battery module 100B are connected to each other through a strip-shaped bus bar 501a as the power supply line 501 illustrated in Fig. 1. The high potential electrode 10A of the battery module 100C and the low potential electrode 10B of the battery module 100D are connected to each other through a strip-shaped bus bar 501a as the power supply line 501 illustrated in Fig. 1.

The high potential electrode 10A of the battery module 100A is connected to the service plug 520 through a power supply line Q1 as the power supply line 501 illustrated in Fig. 1, and the low potential electrode 10B of the battery module 100C is connected to the service plug 520 through a power supply line Q2 as the power supply line 501 illustrated in Fig. 1. With the service plug 520 turned on, the battery modules 100A to 100D are connected in series. In this case, a potential of the high potential electrode 10A of the battery module 100D is the highest, and a potential of the low potential electrode 10B of the battery module 100B is the lowest.

The service plug 520 is turned off by a worker during maintenance of the battery system 500, for example. When the service plug 520 is turned off, a series circuit composed of the battery modules 100A and 100B and a series circuit composed of the battery modules 100C and 100D are electrically separated from each other. In this case, the total voltage of the series circuit composed of the battery modules 100A and 100B and the total voltage of the series circuit composed of the battery modules 100C and 100D become equal to each other. This prevents a high voltage from being generated in the battery system 500 during maintenance.

The low potential electrode 10B of the battery module 100B is connected to the contactor 102 through a power supply line Q3 as the power supply line 501 illustrated in Fig. 1, and the high potential electrode 10A of the battery module 100D is connected to the contactor 102 through a power supply line Q4 as the power supply line 501 illustrated in Fig. 1. The contactor 102 is connected to the HV connector 510 through power supply lines Q5 and Q6 as the power supply lines 501 illustrated in Fig. 1. The HV connector 510 is connected to the load such as the motor of the electric vehicle.

With the contactor 102 turned on, the battery module 100B is connected to the HV connector 510 through the power supply lines Q3 and Q5 while the battery module 100D is connected to the HV connector 510 through the power supply lines Q4 and Q6. Accordingly, electric power is supplied from the battery modules 100A to 100D to the load.

When the contactor 102 is turned off, connection between the battery module 100B and the HV connector 510 and connection between the battery module 100D and the HV connector 510 are cut off.

Connection of the communication circuits 24 in the battery modules 100A to 100D and the battery ECU 101 are similar to the connection illustrated in Fig. 13.

### (9) Effects of First Embodiment

As described above, in the battery module 100 and the battery system 500 according to the first embodiment, the detection circuit 20 and the communication circuit 24 are mounted on the common printed circuit board 21. Therefore, the wiring between the detection circuit 20 and the communication circuit 24 becomes short and simple. Thus, an arrangement space between the detection circuit 20 and the communication circuit 24 is reduced.

As a result, the cell information of the plurality of battery modules 100 can be intensively managed without increasing the size of the battery module 100.

The battery ECU 101 can individually control charges and discharges of the battery cells 10 in the plurality of battery modules 100 based on the cell information of the plurality of battery modules 100. Therefore, the charged capacities of the plurality of battery cells 10 in the plurality of battery modules 100 are kept substantially equal. This prevents some of the battery cells 10 from being excessively charged and discharged. As a result, the battery cells 10 can be prevented from deteriorating.

Further, the battery ECU 10 can acquire the cell information of the plurality of battery modules 100 by being connected to not all the battery modules 100 but the two battery modules 100. Therefore, the wiring for transmitting the cell information of the plurality of battery modules 100 to the battery ECU 101 is simplified.

### [2] Second Embodiment

Battery modules 100 (100A to 100D) and a battery system 500 according to a second embodiment will be described by referring to differences from the battery modules 100 and the battery system 500 according to the first embodiment.

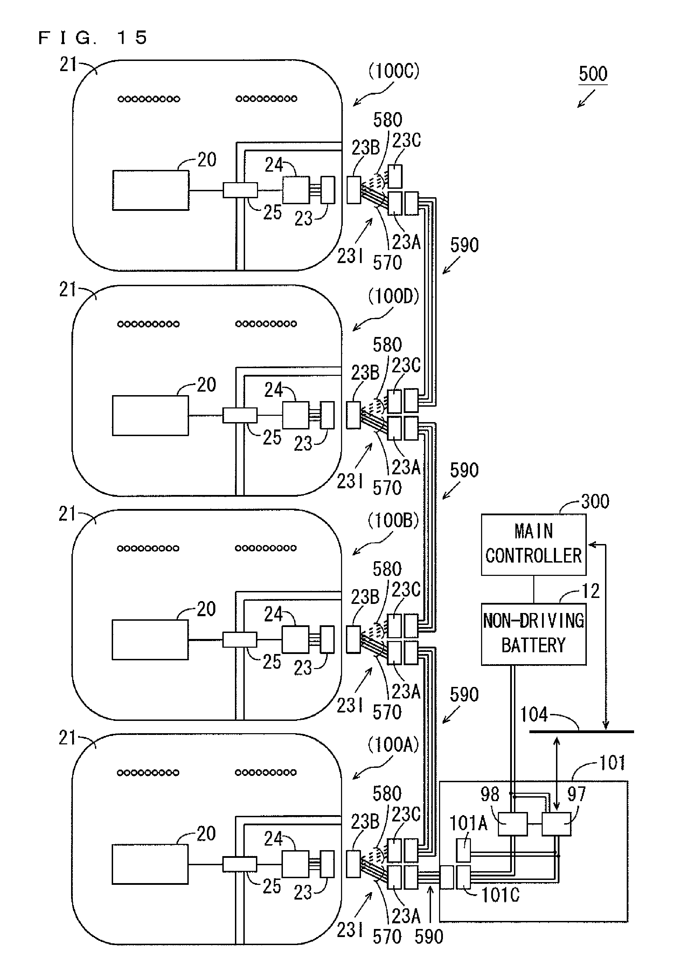

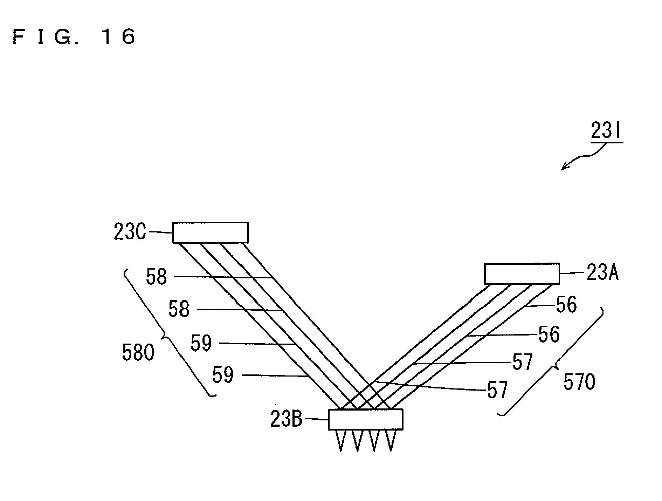

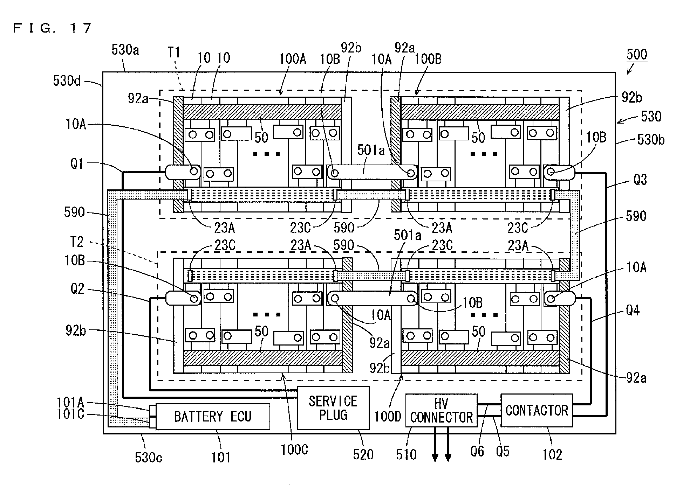

Fig. 15 is a diagram illustrating connection between a plurality of printed circuit boards 21 and a battery ECU 101 in the battery system 500 according to the second embodiment. Fig. 16 is a schematic plan view of an input/output harness used to connect a communication circuit 24 in the battery module 100 according to the second embodiment. Fig. 17 is a schematic plan view illustrating an example of a detailed configuration of the battery system 500 according to the second embodiment.

Fig. 15 illustrates four printed circuit boards respectively corresponding to the battery modules 100A to 100D. A connector 23 on each of the printed circuit boards 21 is connected to two signal terminals and two power supply terminals. On the other hand, the battery ECU 101 includes a first input/output connector 101A and a second input/output connector 101C instead of an input connector 101a and an output connector 101c illustrated in Fig. 14. The battery ECU 101 further includes an MPU (Microprocessor) 97 and a switch circuit 98. The first input/output connector 101A is connected to the MPU 97 by two connecting lines. The second input/output connector 101C is connected to a non-driving battery 12 by two connecting lines through the switch circuit 98. The second input/output connector 101C is connected to the MPU 97 by two connecting lines.

The MPU 97 is connected to enable communication with a main controller 300 in an electric vehicle via a bus 104. The non-driving battery 12 supplies electric power to the MPU 97 and the switch circuit 98. The MPU 97 controls ON and OFF of the switch circuit 98. If the switch circuit 98 is ON, electric power generated by the non-driving battery 12 is output from the second input/output connector 101C via the switch circuit 98.

As illustrated in Fig. 16, an input/output harness 23I includes a first input/output connector 23A, a relay connector 23B, a second input/output connector 23C, and harnesses 570 and 580. The first input/output connector 23A has a plurality of terminals for communication and electric power. The relay connector 23B has a plurality of terminals for communication and electric power. The second input/output connector 23C has a plurality of terminals for communication and electric power. The harness 570 connects the plurality of terminals of the first input/output connector 23A and the plurality of terminals of the relay connectors 23B. The harness 580 connects the plurality of terminals of the relay connector 23B and the plurality of terminals of the input/output connector 23C. The harness 570 includes two communication lines 56 and two communication lines 57, and the harness 580 includes two communication lines 58 and two power supply lines 59.

The two communication lines 56 and the two communication lines 58 are electrically connected to each other through the terminals of the relay connector 23B. Thus, a differential signal input to the first input/output connector 23A is output from the relay connector 23B via the two communication lines 56 while being output from the second input/output connector 23C via the two communication lines 58. Similarly, a differential signal input to the second input/output connector 23C is output from the relay connector 23B via the two communication lines 58 while being output from the first input/output connector 23A via the two communication lines 56.

The two power supply lines 57 and the two power supply lines 59 are electrically connected to each other through the terminals of the relay connector 23B. Thus, electric power input to the first input/output connector 23A is output from the relay connector 23B via the two power supply lines 57 while being output from the second input/output connector 23C via the two power supply lines 59.

A plurality of input/output harnesses 23l are used to correspond to the plurality of battery modules 100A to 100D. Similarly to the input/output harnesses 23H (see Fig. 11) in the first embodiment, the input/output harnesses 231 each include the first and second input/output connectors 23A and 23C, respectively, also arranged on upper surfaces of the battery modules 100A to 100D in the present embodiment.

As illustrated in Figs. 15 and 17, a plurality of harnesses 590 including a plurality of connecting lines are used for connection among the plurality of input/output harnesses 231. Each of the harnesses 590 includes two connecting lines for communication and two connecting lines for electric power. The relay connectors 23B in the input/output harnesses 231 corresponding to the battery modules 100A to 100D are connected to the connectors 23 in the battery modules 100A to 100D, respectively. The first input/output connector 23A in the input/output harness 231 corresponding to the battery module 100A is connected to the second input/output connector 101C in the battery ECU 101 through the harness 590.

The second input/output connector 23C in the input/output harness 23I corresponding to the battery module 100A and the first input/output connector 23A in the input/output harness 23I corresponding to the battery module 100B are connected to each other through the harness 590. The second input/output connector 23C in the input/output harness 23I corresponding to the battery module 100B and the first input/output connector 23A in the input/output harness 231 corresponding to the battery module 100D are connected to each other through the harness 590. The second input/output connector 23C in the input/output harness 23I corresponding to the battery module 100D and the first input/output connector 23A in the input/output harness 23I corresponding to the battery module 100C are connected to each other through the harness 590.

A terminal resistor is connected to the second input/output connector 23C in the input/output harness 231 corresponding to the battery module 100C. Similarly, a terminal resistor is connected to the first input/output connector 101A in the battery ECU 101. Thus, the communication lines 56 and 58 in the plurality of input/output harnesses 231 and the plurality of harnesses 590 constitute a bus.

Thus, the MPU 97 in the battery ECU 101 and the communication circuits 24 in the battery modules 100A to 100D can communicate with each other. Electric power from the non-driving battery 12 can be supplied to the communication circuits 24 in the battery modules 100A to 100D via the switch circuit 98 in the battery ECU 101.

### [3] Third Embodiment

Battery modules 100 and a battery system 500 according to a third embodiment will be described by referring to differences from the battery modules 100 and the battery system 500 according to the first embodiment. In the battery system 500 according to the present embodiment and battery systems 500 according to fourth and fifth embodiments, described below, communication circuits 24 in four battery modules 100 and a battery ECU 101 are also connected in series, as illustrated in Fig. 13.

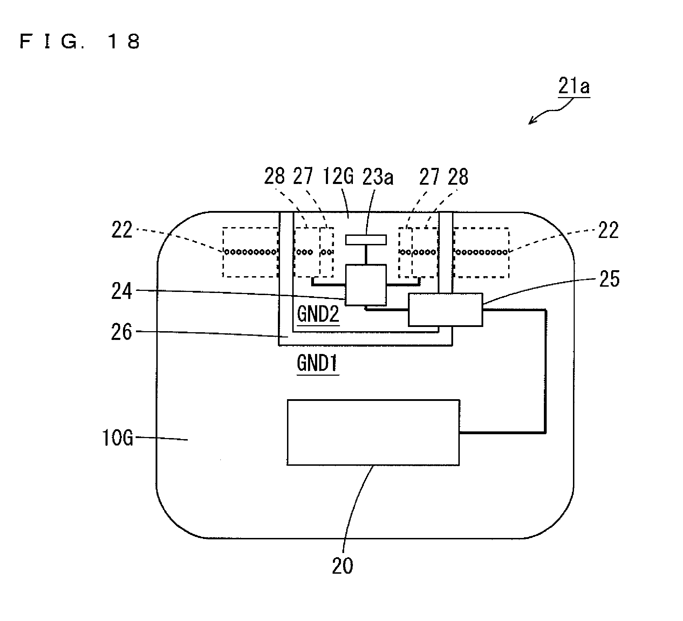

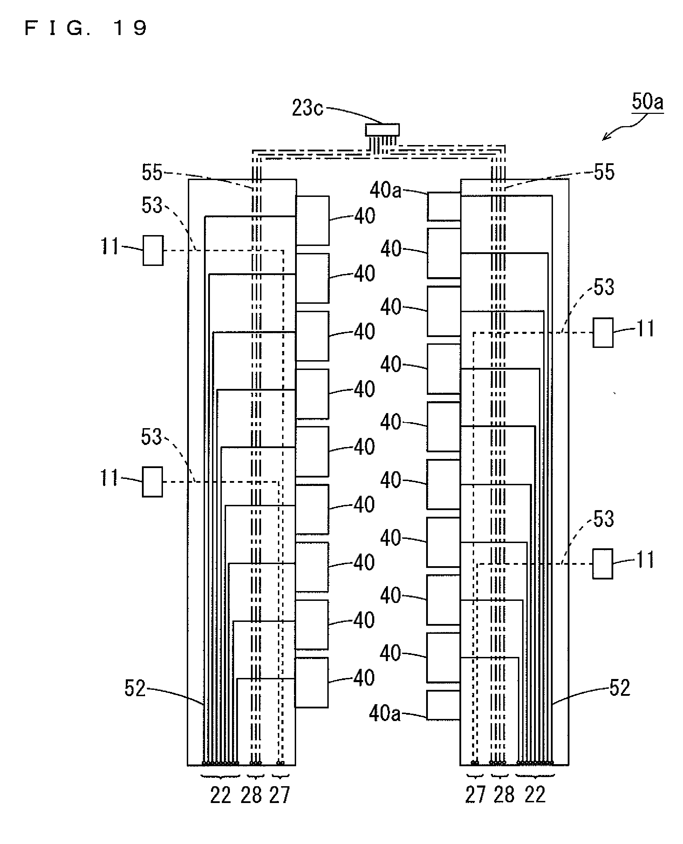

Fig. 18 is a schematic plan view of a printed circuit board 21a included in the battery module 100 according to the third embodiment, and Fig. 19 is a schematic plan view of FPC boards 50a connected to the printed circuit board 21a illustrated in Fig. 18.

As illustrated in Fig. 18, the printed circuit board 21a has a substantially rectangular shape. A detection circuit 20, a communication circuit 24, and an insulating element 25 are mounted on the printed circuit board 21a. Two sets of connection terminals 22, two sets of connection terminals 27, and two sets of connection terminals 28, and an input connector 23a are formed on the printed circuit board 21a. Illustration of the resistors R and the switching elements SW illustrated in Fig. 2 is omitted.

The printed circuit board 21a includes a first mounting region 10G, a second mounting region 12G, and a strip-shaped insulating region 26.

The second mounting region 12G is formed in a substantially central portion of an upper part of the printed circuit board 21. The insulating region 26 is formed to extend along the second mounting region 12G. The first mounting region 10G is formed in the remaining part of the printed circuit board 21a. The first mounting region 10G and the second mounting region 12G are separated from each other by the insulating region 26. Thus, the first mounting region 10G and the second mounting region 12G are electrically insulated from each other by the insulating region 26.

The detection circuit 20 is mounted while the two sets of connection terminals 22 are formed in the first mounting region 10G. The detection circuit 20 and the connection terminals 22 are electrically connected to each other through connecting lines, respectively, on the printed circuit board 21a. The plurality of battery cells 10 (see Fig. 1) in the battery module 100 are connected to the detection circuit 20 as a power source of the detection circuit 20. A ground pattern GND1 is formed in the first mounting region 10G not including a mounting region of the detection circuit 20, formation regions of the connection terminals 22, and formation regions of the connecting lines. The ground pattern GND1 is held at a reference potential of the battery module 100.

The communication circuit 24 is mounted while the input connector 23a and the two sets of connection terminals 27 and the two sets of connection terminals 28 are formed in the second mounting region 12G. The communication circuit 24 is electrically connected to the input connector 23a and the connection terminals 27 and 28 through connecting lines, respectively, on the printed circuit board 21a. The non-driving battery 12 (see Fig. 1) included in the electric vehicle are connected to the communication circuit 24 as a power source of the communication circuit 24. A ground pattern GND2 is formed in the second mounting region 12G not including a mounting region of the communication circuit 24, a formation region of the input connector 23a, formation regions of the connection terminals 22, and formation regions of the connecting lines. The ground pattern GND2 is held at a reference potential of the non-driving battery 12.

The insulating element 25 is mounted over the insulating region 26. The insulating element 25 electrically insulates the ground pattern GND1 and the ground pattern GND2 from each other while transmitting a signal between the detection circuit 20 and the communication circuit 24.

Two FPC boards 50a are connected to the two sets of connection terminals 22, the two sets of connection terminals 27, and the two sets of connection terminals 28 in the printed circuit board 21a, respectively. As illustrated in Fig. 19, the FPC boards 50a are provided with a plurality of conductor lines 52, 53, and 55. In the present embodiment, one of the FPC boards 50a is provided with nine conductor lines 52, two conductor lines 53, and three conductor lines 55. The other FPC board 50a is provided with nine conductor lines 52, two conductor lines 53, and four conductor lines 55. The respective numbers of conductor lines 52, 53, and 55 provided in one of the two FPC boards 50a are thus made substantially equal to those in the other FPC board 50a so that the respective widths of the two FPC boards 50a can be made substantially equal.

The conductor line 52 connects bus bars 40 and 40a to the connection terminals 22 in the printed circuit board 21 a. Thus, the detection circuit 20 detects each of voltages of the battery cells 10 (see Fig. 1) via the bus bars 40 and 40a, the conductor line 52, and the connection terminals 22. The communication circuit 24 calculates a terminal voltage of each of the battery cells 10 based on a voltage detected by the detection circuit 20 while calculating a current flowing through the battery module 100.

The conductor line 53 connects each of thermistors 11 to connection terminals 27 in the printed circuit board 21 a. Thus, a signal output from the thermistor 11 is fed to the communication circuit 24 via the conductor line 53 and the connection terminals 27. Thus, the communication circuit 24 acquires a temperature of each of the battery modules 100.

The conductor line 55 connects an output connector 23c to connection terminals 28 in the printed circuit board 21 a. The input connector 23a illustrated in Fig. 18 and the output connector 23c illustrated in Fig. 19 are connected to the adjacent battery modules 100 through the harnesses 560, respectively, as illustrated in Fig. 13.

The communication circuits 24 in the four battery modules 100 and the battery ECU 101 are connected to each other, as illustrated in Fig. 13, so that each of the battery modules 100 can transmit cell information to the other battery module 100 or the battery ECU 101 while receiving cell information from the other battery module 100.

As described above, in the battery module 100 according to the present embodiment and the battery system 500 including the same, the conductor line 52 for detecting a voltage of each of the battery cells 10, the conductor line 53 for acquiring the temperature of the battery cell 10, and the conductor line 55 for communicating with the other battery module 100 are formed in each of the two FPC boards 50a. In this case, the conductor lines 52, 53, and 55 can be integrally handled. Thus, the battery module 100 further becomes easier to assemble. The conductor lines 52, 53, and 55 concentrate on the FPC boards 50a so that a space where the conductor lines 52, 53, and 55 do not exist is ensured to be large around the plurality of battery cells 10. Thus, heat dissipation characteristics of the plurality of battery cells 10 are further improved.

### [4] Fourth Embodiment

A battery module 100 and a battery system 500 according to a fourth embodiment will be described by referring to differences from the battery modules 100 and the battery system 500 according to the first embodiment.

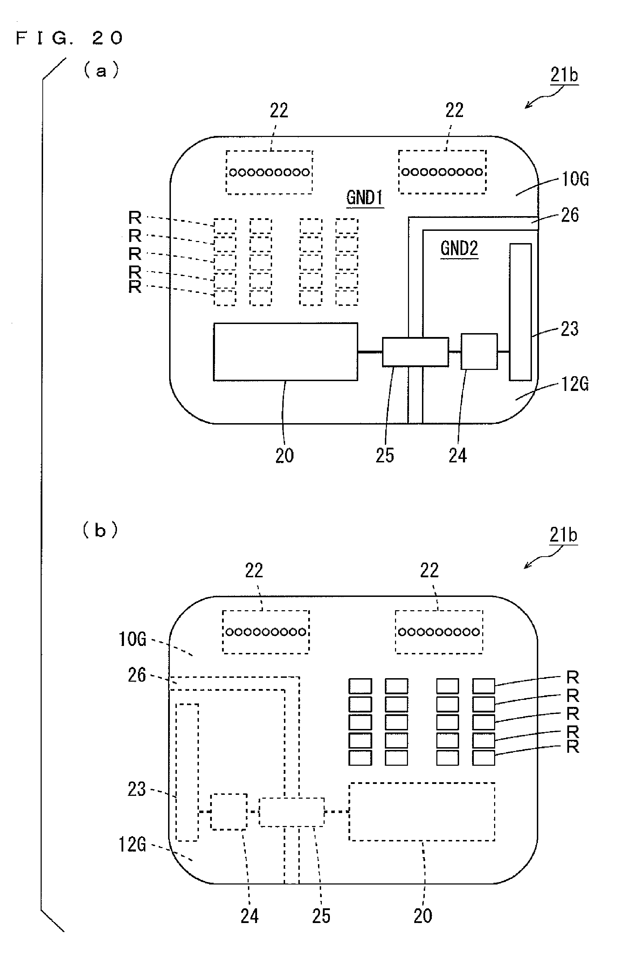

Fig. 20 is a schematic plan view of a printed circuit board 21b included in the battery module 100 according to the fourth embodiment. The printed circuit board 21 has a substantially rectangular shape, and has one surface and the other surface. Figs. 20 (a) and 20 (b) illustrate one surface and the other surface of the printed circuit board 21 b, respectively.

As illustrated in Fig. 20 (a), a detection circuit 20, a communication circuit 24, and an insulating element 25 are mounted on one surface of the printed circuit board 21b while connection terminals 22 and a connector 23 are formed thereon. As illustrated in Fig. 20 (b), a plurality of resistors R are mounted while the connection terminals 22 are formed on the other surface of the printed circuit board 21 b. Illustration of switching elements SW illustrated in Fig. 2 is omitted.

The printed circuit board 21b includes a first mounting region 10G, a second mounting region 12G, and a strip-shaped insulating region 26, as in the first embodiment.

The plurality of resistors R on the other surface of the printed circuit board 21b are arranged in a position above a position corresponding to the detection circuit 20 and the communication circuit 24. Thus, heat generated from the resistors R can be efficiently dissipated. The heat generated from the resistors R can be prevented from being transmitted to the detection circuit 20 and the communication circuit 24. As a result, the detection circuit 20 and the communication circuit 24 can be prevented from malfunctioning and deteriorating by the heat.

### [5] Fifth Embodiment

Fig. 21 is an external perspective view illustrating a battery module 100 according to a fifth embodiment. The battery module 100 illustrated in Fig. 21 will be described by referring to differences from the battery module 100 illustrated in Fig. 3.

In the battery module 100 illustrated in Fig. 21, each of battery cells 10 has a plus electrode 10a and a minus electrode 10b arranged on an upper surface portion to line up in the Y-direction. Each of the electrodes 10a and 10b is provided to protrude upward. Plate-shaped bus bars 40p are fitted in the two adjacent electrodes 10a and 10b, respectively. In the state, the electrodes 10a and 10b are laser-welded to the bus bars 40p, respectively. Thus, the plurality of battery cells 10 are connected in series.

In the battery module 100 according to the present embodiment, a battery block 10BB having a substantially rectangular parallelepiped shape is also formed of the plurality of battery cells 10, a pair of end surface frames 92, a pair of upper end frames 93, and a pair of lower end frames 94.

The plurality of bus bars 40p are arranged in two rows in the X-direction. Two FPC boards 50 are arranged inside the bus bars 40p in two rows. One of the FPC boards 50 is arranged between gas vent valves 10v in the plurality of battery cells 10 and the plurality of bus bars 40p in one of the rows not to overlap the gas vent valves 10v in the plurality of battery cells 10. Similarly, the other FPC board 50 is arranged between the gas vent valves 10v in the plurality of battery cells 10 and the plurality of bus bars 40p in the other row not to overlap the gas vent valves 10v in the plurality of battery cells 10.

The one FPC board 50 is connected in common to the plurality of bus bars 40p in one of the rows. The other FPC board 50 is connected in common to the plurality of bus bars 40p in the other row. Each of the FPC boards 50 is bent downward at an upper end portion of one of the end surface frames 92, and is connected to a printed circuit board 21.

Each of the FPC boards 50 has a similar configuration to that of the FPC board 50 illustrated in Fig. 7, and is folded in half along a folding line in the X-direction. In this case, even if the width of each of the FPC boards 50 is large, the FPC board 50 is folded so that it is prevented from overlapping the gas vent valves 10v. When pressure inside the battery cell 10 rises to a predetermined value so that gases are exhausted from the gas vent valves 10v, therefore, each of the FPC boards 50 is prevented from preventing the exhaustion of gases. The FPC boards 50 can be prevented from being damaged by the exhaustion of gases.

A protecting member 95 having a pair of side surface portions and a bottom surface portion is attached to the end surface frame 92 to protect both ends and the bottom of the printed circuit board 21. The printed circuit board 21 is protected by being covered with the protecting member 95. The protecting member 95 need not be provided. A detection circuit 20, a communication circuit 24, and a connector 23 are provided on the printed circuit board 21.

A cooling plate 96 is provided to contact lower surfaces of the plurality of battery cells 10. The cooling plate 96 includes a refrigerant inlet 96a and a refrigerant outlet 96b. A circulation path that communicates with the refrigerant inlet 96a and the refrigerant outlet 96b is formed inside the cooling plate 96. When a refrigerant such as cooling water flows into the refrigerant inlet 96a, the refrigerant flows out of the refrigerant outlet 96b after passing through the circulation path inside the cooling plate 96. Thus, the cooling plate 96 is cooled. As a result, the plurality of battery cells 10 are cooled.

The connector 23 illustrated in Fig. 21 is connected to the connector 23 in the other battery module 100 using an input/output harness 23H illustrated in Fig. 12, as in the connection illustrated in Fig. 13, so that the communication circuit 24 in the battery module 100 can be connected to the communication circuit 24 in the other battery module 100. In this case, a harness 560 (see Fig. 13) is used for connection between an input connector 23a and the other battery module 100 and connection between an output connector 23c and the other battery module 100. Thus, the communication circuit 24 in the battery module 100 can transmit cell information of the battery module 100 to the communication circuit 24 in the other battery module 100 while receiving cell information from the other battery module 100. In Fig. 21, harnesses 540 and 550 in the input/output harness 23H are indicated by a solid line and a dotted line, respectively.

In this example, both the input connector 23a and the output connector 23c in the input/output harness 23H are arranged on an upper surface of the battery block 10BB. Thus, the harnesses 540 and 550 for connecting the communication circuit 24 and the other battery module 100 are pulled out upward from the printed circuit board 21. A conductor line 52 (see Fig. 8) for connecting the detection circuit 20 and the plurality of bus bars 40 and 40a is pulled out upward from the printed circuit board 21 with the FPC boards 50 connected to the printed circuit board 21.

In the battery module 100 according to the present embodiment, the harnesses 540 and 550 for communication and the conductor line 52 for voltage detection are thus pulled out in the same direction (Z-direction) from the printed circuit board 21. Thus, the conductor line 52 and the harnesses 540 and 550 are arranged to concentrate in one direction of the printed circuit board 21. Therefore, the printed circuit board 21 becomes easy to handle, and the battery module 100 becomes easy to assemble. Since the conductor line 52 and the harnesses 540 and 550 do not exist around the printed circuit board 21 excluding the one direction, heat dissipation characteristics of the detection circuit 20 and the communication circuit 24 are improved.

In an example illustrated in Fig. 21, the battery module 100 may be provided with a terminal cover 70 to cover the electrodes 10a and 10b on one side of each of the battery cells 10 and the FPC board 50 on the one side, and the input connector 23a and the output connector 23c may be fixed to an upper surface of the terminal cover 70, like that illustrated in Fig. 11.

While the input connector 23a and the output connector 23c are arranged in positions, respectively, on an upper surface of the end surface frame 92 to which the printed circuit board 21 is attached or an upper surface of the battery cell 10 in the vicinity thereof in the example illustrated in Fig. 21, the present invention is not limited to this. The input connector 23a and the output connector 23c may be arranged in other positions, respectively, on the upper surface of the battery block 10BB. For example, the input connector 23a may be arranged in a position on the upper surface of the end surface frame 92 to which the printed circuit board 21 is attached or the upper surface of the battery cell 10 in the vicinity thereof, and the output connector 23c may be arranged in a position on the upper surface of the end surface frame 92 to which the printed circuit board 21 is not attached or the upper surface of the battery cell 10 in the vicinity thereof.

In this case, as illustrated in Fig. 13, the harness 560 for connecting the input connector 23a and the other battery module 100 can be shortened. The harness 560 for connecting the output connector 23c and the other battery module 100 can be shortened.

### [6] Sixth Embodiment

A battery module 100 and a battery system 500 according to a sixth embodiment will be described by referring to differences from the battery module 100 and the battery system 500 according to the first embodiment.

### (1) Configuration of Battery Module

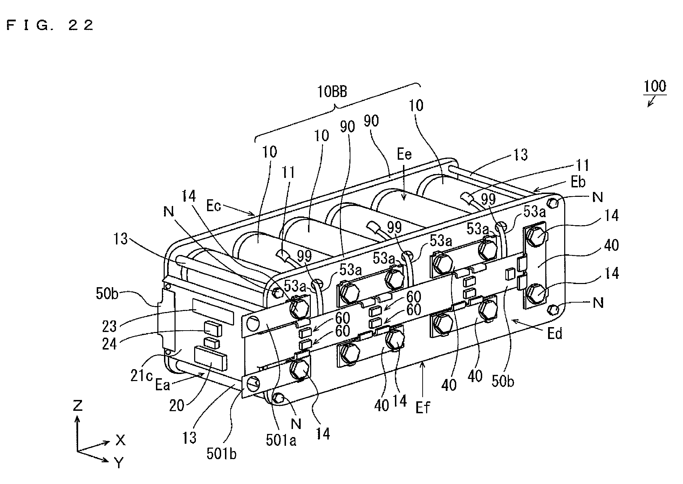

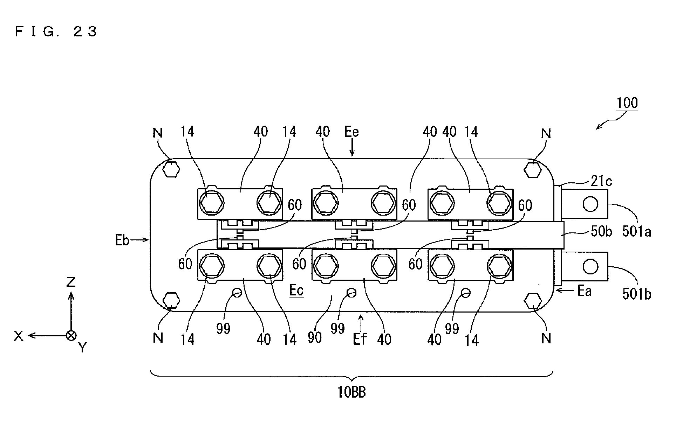

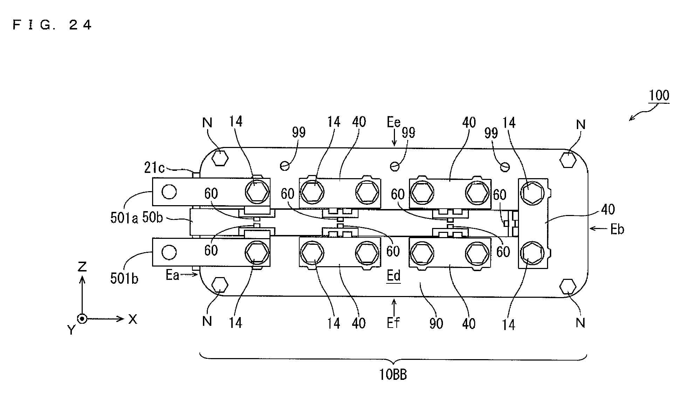

Fig. 22 is an external perspective view illustrating a battery module 100 according to the sixth embodiment, Fig. 23 is a side view on one side of the battery module 100 illustrated in Fig. 22, and Fig. 24 is a side view on the other side of the battery module 100 illustrated in Fig. 22.

As illustrated in Figs. 22 to 24, the battery module 100 includes a battery block 10BB, a printed circuit board 21c, thermistors 11, and FPC boards 50b. The printed circuit board 21c is provided with a detection circuit 20, a communication circuit 24, and a connector 23.

The battery block 10BB mainly includes a plurality of cylindrical battery cells 10 and a pair of battery holders 90 for holding the plurality of battery cells 10. Each of the battery cells 10 has a cylindrical outer shape having opposite end surfaces (a so-called columnar shape). A plus electrode is formed on one of the end surfaces of the battery cell 10. A minus electrode is formed on the other end surface of the battery cell 10.

The plurality of battery cells 10 are arranged in parallel so that their respective axes are parallel to one another. In the example illustrated in Figs. 22 to 24, the axis of each of the battery cells 10 is parallel to the Y-direction. Half (six in this example) of the battery cells 10 are arranged in an upper stage, and remaining half (six in this example) of the battery cells 10 are arranged in a lower stage.

In each of the upper and lower stages, the plurality of battery cells 10 are arranged so that a positional relationship between a plus electrode and a minus electrode of one of the two adjacent battery cells 10 is opposite to that in the other battery cell 10. Thus, the plus electrode of one of the two adjacent battery cells and the minus electrode of the other battery cell are adjacent to each other, and the minus electrode of the one battery cell 10 and the plus electrode of the other battery cell 10 are adjacent to each other.

The battery holder 90 is composed of a plate-shaped member having a substantially rectangular shape formed of resin, for example. The battery holder 90 has one surface and the other surface. The one surface and the other surface of the battery holder 90 are referred to as an outer surface and an inner surface, respectively. A pair of battery holders 90 is arranged so that a plurality of battery cells 10 are sandwiched therebetween. In this case, one of the battery holders 90 is arranged to oppose the one end surface of each of the battery cells 10, and the other battery holder 90 is arranged to oppose the other end surface of the battery cell 10.

Holes are formed at four corners of the battery holder 90, respectively, and both ends of a stick-shaped fastener member 13 are inserted into the holes, respectively. Male threads are formed at both ends of the fastener member 13, respectively. In this state, nuts N are attached to both the ends of the fastener member 13, respectively, so that the plurality of battery cells 10 and the pair of battery holders 90 are integrally fixed. Three holes 99 are formed at equal spacings in a longitudinal direction of the battery holder 90. A conductor line 53a is inserted through the hole 99. In this example, the longitudinal direction of the battery holder 90 is parallel to the X-direction.

Consider a virtual rectangular parallelepiped surrounding the battery block 10BB. Out of six virtual surfaces of the rectangular parallelepiped, the virtual surface opposing outer peripheral surfaces of the battery cells 10 positioned in the upper stage and the lower stage at one end in the X-direction is referred to as a side surface Ea of the battery block 10BB, and the virtual surface opposing outer peripheral surfaces of the battery cells 10 positioned in the upper stage and the lower stage at the other end in the X-direction is referred to as a side surface Eb of the battery block 10BB.

Out of the six virtual surfaces of the rectangular parallelepiped, the virtual surface opposing one end surfaces in the Y-direction of the plurality of battery cells 10 is referred to as a side surface Ec of the battery block 10BB, and the virtual surface opposing the other end surfaces in the Y-direction of the plurality of battery cells 10 is referred to as a side surface Ed of the battery block 10BB.

Further, out of the six virtual surfaces of the rectangular parallelepiped, the virtual surface opposing outer peripheral surfaces of the plurality of battery cells 10 in the upper stage is referred to as a side surface Ee of the battery block 10BB, and the virtual surface opposing outer peripheral surfaces of the plurality of battery cells 10 in the lower stage is referred to as a side surface Ef of the battery block 10BB.

The side surfaces Ea and Eb of the battery block 10BB are perpendicular to a direction in which the plurality of battery cells 10 in the upper stage or the lower stage line up. More specifically, the side surfaces Ea and Eb of the battery block 10BB are parallel to a YZ plane and oppose each other. The side surfaces Ec and Ed of the battery block 10BB are perpendicular to an axial direction (Y-direction) of each of the battery cells 10. More specifically, the side surfaces Ec and Ed of the battery block 10BB are parallel to an XZ plane and oppose each other. The side surfaces Ee and Ef of the battery block 10BB are parallel to the direction in which the plurality of battery cells 10 in the upper stage or the lower stage line up (X-direction) and the axial direction (Y-direction) of each of the battery cells 10. More specifically, the side surfaces Ee and Ef of the battery block 10BB are parallel to an XY plane and oppose each other.

One of the plus electrode and the minus electrode of each of the battery cells 10 is arranged on the side surface Ec of the battery block 10BB, and the other electrode is arranged on the side surface Ed of the battery block 10BB.

In the battery block 10BB, the plurality of battery cells 10 are connected in series by a plurality of bus bars 40 and hexagon bolts 14. More specifically, a plurality of holes are formed to correspond to the plurality of battery cells 10 in the upper stage and the lower stage in each of the battery holders 90. The plus electrode and the minus electrode of each of the battery cells 10 are fitted in the corresponding holes in the pair of battery holders 90, respectively. Thus, the plus electrode and the minus electrode of each of the battery cells 10 protrude from outer surfaces of the pair of battery holders 90.

As described above, in the battery block 10BB, the battery cells 10 are arranged so that a positional relationship between the plus electrode and the minus electrode in one of the two adjacent battery cells 10 is opposite to that in the other battery cell 10. Therefore, between the two adjacent battery cells 10, the plus electrode of one of the battery cells 10 and the minus electrode of the other battery cell 10 are adjacent to each other, and the minus electrode of one of the battery cells 10 and the plus electrode of the other battery cell 10 are adjacent to each other. In this state, the bus bar 40 is attached to the plus electrode and the minus electrode being in close proximity to each other so that the plurality of battery cells 10 are connected in series.

In the following description, out of the six battery modules 10 arranged in the upper stage of the battery block 10BB, the battery cell 10 closest to the side surface Ea to the battery cell 10 closest to the side surface Eb are referred to as first to sixth battery cells 10. Out of the six battery modules 10 arranged in the lower stage of the battery block 10BB, the battery cell 10 closest to the side surface Eb to the battery cell 10 closest to the side surface Ea are referred to as seventh to 12-th battery cells 10.

In this case, the common bus bar 40 is attached to the minus electrode of the first battery cell 10 and the plus electrode of the second battery cell 10. The common bus bar 40 is attached to the minus electrode of the second battery cell 10 and the plus electrode of the third battery cell 10. Similarly, the common bus bar 40 is attached to the minus electrode of each of the odd numbered battery cells 10 and the plus electrode of each of the even numbered battery cells 10 adjacent thereto. The common bus bar 40 is attached to the minus electrode of each of the even numbered battery cells 10 and the plus electrode of each of the odd numbered battery cells 10 adjacent thereto.

One end of a bus bar 501a for supplying electric power to the exterior is attached to the plus electrode of the first battery cell 10 as the power supply line 501 illustrated in Fig. 1. One end of a bus bar 501b for supplying electric power to the exterior is attached to the minus electrode of the 12-th battery cell 10 as the power supply line 501 illustrated in Fig. 1. The respective other ends of the bus bars 501a and 501b are pulled out in a direction in which the plurality of battery cells 10 line up (X-direction).

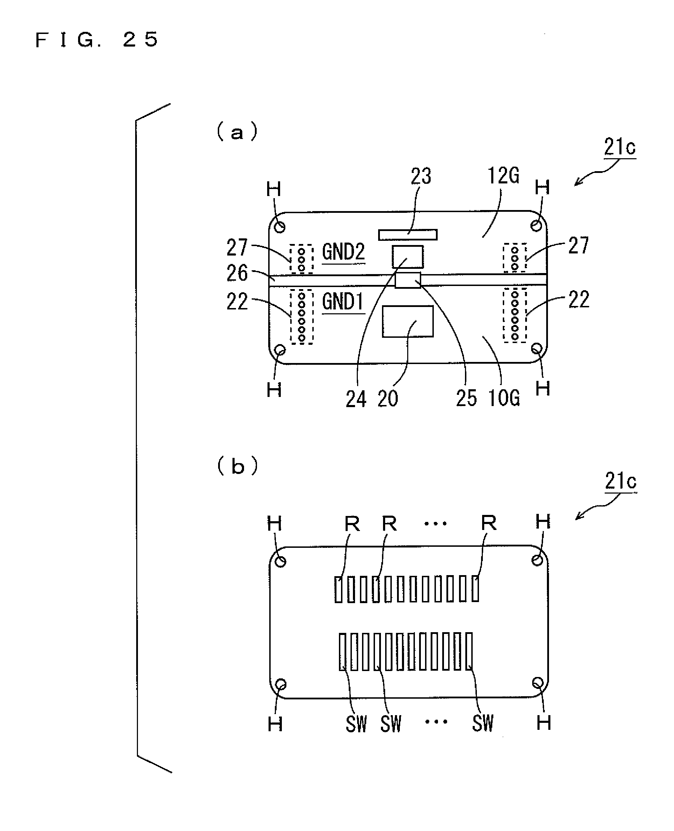

The printed circuit board 21c including the detection circuit 20, the communication circuit 24, and the connector 23 is attached to the side surface Ea of the battery block 10BB. A long-sized FPC board 50b is provided to extend from the side surface Ec onto the side surface Ea of the battery block 10BB. A long-sized FPC board 50b is provided to extend from the side surface Ed onto the side surface Ea of the battery block 10BB. The FPC boards 50b have a similar configuration to that of the FPC boards 50 illustrated in Fig. 8 except that it further includes a conductor line 53 (see Fig. 19) for connecting each of the plurality of thermistors 11 to connection terminals 27 (see Fig. 25, described below) in the printed circuit board 21c. The PTC elements 60 are arranged to be in close proximity to the plurality of bus bars 40 and 40a, respectively, on the FPC boards 50.

As illustrated in Fig. 23, one of the FPC boards 50b is arranged to extend in a direction in which the plurality of battery cells 10 line up (X-direction) at the center on the side surface Ec of the battery block 10BB. The FPC board 50b is connected in common to the plurality of bus bars 40. As illustrated in Fig. 24, the other FPC board 50b is arranged to extend in a direction in which the plurality of battery cells 10 line up (X-direction) at the center on the side surface Ed of the battery block 10BB. The FPC board 50b is connected in common to the plurality of bus bars 40 and 40a.

The FPC board 50b on the side surface Ec is bent at a right angle upward to the side surface Ea at one end of the side surface Ec of the battery block 10BB, and is connected to the printed circuit board 21c. The FPC board 50b on the side surface Ed is bent at a right angle upward to the side surface Ea at one end of the side surface Ed of the battery block 10BB, and is connected to the printed circuit board 21c.

The thermistors 11 are connected to the conductor lines provided in the FPC boards 50b through the conductor lines 53a. The bus bars 40 and 40a in the battery module 100 and the thermistors 11 are electrically connected to the printed circuit board 21c by the conductor lines formed on the FPC boards 50b, respectively.

### (2) Example of Configuration of Printed Circuit Board

Fig. 25 is a schematic plan view illustrating an example of a configuration of the printed circuit board 21c according to the sixth embodiment. The printed circuit board 21c has a substantially rectangular shape, and has one surface and the other surface. Figs. 25 (a) and 25 (b) illustrate one surface and the other surface of the printed circuit board 21c, respectively. Holes H are formed at four corners of the printed circuit board 21c, respectively.

As illustrated in Fig. 25 (a), the printed circuit board 21c includes a first mounting region 10G, a second mounting region 12G, and a strip-shaped insulating region 26 formed on its one surface.

The second mounting region 12G is formed in an upper part of the printed circuit board 21. The insulating region 26 is formed to extend along the second mounting region 12G. The first mounting region 10G is formed in the remaining part of the printed circuit board 21c. The first mounting region 10G and the second mounting region 12G are separated from each other by the insulating region 26. Thus, the first mounting region 10G and the second mounting region 12G are electrically insulated from each other by the insulating region 26.

A detection circuit 20 is mounted while two sets of connection terminals 22 are formed in the first mounting region 10G. The detection circuit 20 and the connection terminals 22 are electrically connected to each other through connecting lines, respectively, on the printed circuit board 21c. The plurality of battery cells 10 (see Fig. 22) in the battery module 100 are connected to the detection circuit 20 as a power source of the detection circuit 20. A ground pattern GND1 is formed in the first mounting region 10G not including a mounting region of the detection circuit 20, formation regions of the connection terminals 22, and formation regions of the connecting lines. The ground pattern GND1 is held at a reference potential of the battery module 100.

A communication circuit 24 is mounted while a connector 23 and two sets of connection terminals 27 are formed in the second mounting region 12G. The communication circuit 24 is electrically connected to the connector 23 and the connection terminals 27 through connecting lines, respectively, on the printed circuit board 21c. The relay connector 23b in the input/output harness 23H illustrated in Fig. 12 is attached to the connector 23. The non-driving battery 12 (see Fig. 1) included in the electric vehicle is connected to the communication circuit 24 as a power source of the communication circuit 24. A ground pattern GND2 is formed in the second mounting region 12G not including a mounting region of the communication circuit 24, a formation region of the connector 23, formation regions of the connection terminals 27, and formation regions of the connecting lines. The ground pattern GND2 is held at a reference potential of the non-driving battery 12.

An insulating element 25 is mounted over the insulating region 26. The insulating element 25 electrically insulates the ground pattern GND1 and the ground pattern GND2 from each other while transmitting a signal between the detection circuit 20 and the communication circuit 24.

The two FPC boards 50b (see Fig. 22) are connected to the two sets of connection terminals 22 and the two sets of connection terminals 27 in the printed circuit board 21c, respectively. Each of the FPC boards 50b is provided with a plurality of conductor lines. The plurality of conductor lines provided in the FPC boards 50b connect the bus bars 40 and 40a to the connection terminals 22 in the printed circuit board 21c. Thus, the detection circuit 20 detects a voltage of each of the battery cells 10 (see Fig. 22) via the corresponding bus bar 40 or 40a, the conductor lines provided in the FPC boards 50b, and the connection terminals 22.

Similarly, the plurality of conductor lines provided in the FPC boards 50b connect the conductor lines 53a connected to each of the thermistors 11 to the connection terminals 27 in the printed circuit board 21c. Thus, a signal output from the thermistor 11 is fed to the communication circuit 24 via the conductor line 53a, the conductor lines 53 provided in the FPC boards 50b, and the connection terminals 27. Thus, the communication circuit 24 acquires a temperature of each of the battery modules 100.

As illustrated in Fig. 25 (b), a plurality of resistors R and a plurality of switching elements SW are mounted on the other surface of the printed circuit board 21c. Thus, heat generated from the resistor R can be efficiently dissipated. The heat generated from the resistors R can be prevented from being transmitted to the detection circuit 20 and the communication circuit 24. As a result, the detection circuit 20 and the communication circuit 24 can be prevented from malfunctioning and deteriorating by the heat.

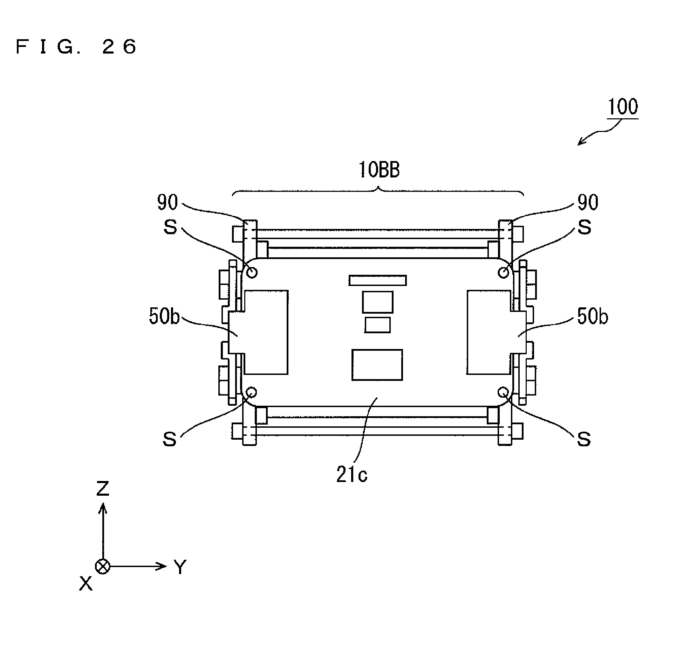

Fig. 26 is a side view illustrating a state where the printed circuit board 21c is attached to the battery block 10BB illustrated in Fig. 22. As illustrated in Fig. 26, a screw S is inserted through the hole H (see Fig. 25) in the printed circuit board 21c. In this state, the screw S is screwed into a screw hole formed in the battery holder so that the printed circuit board 21c is attached to the side surface Ea of the battery block 10BB.

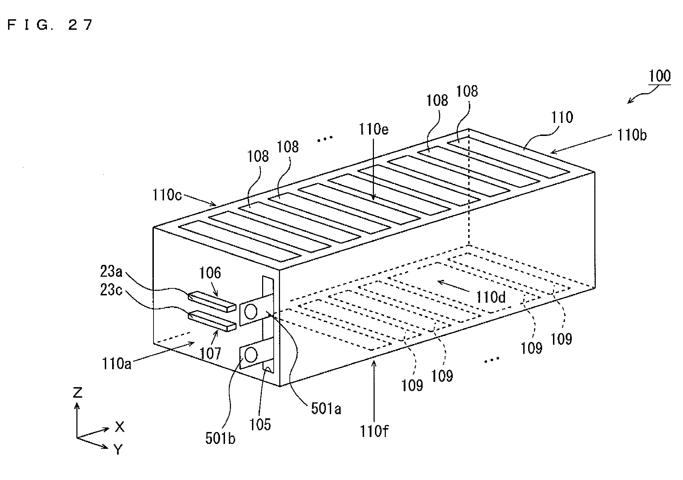

Fig. 27 is an external perspective view of the battery module 100 housed in a casing. As illustrated in Fig. 27, each of the battery modules 100 is housed in the casing 110. The casing 110 prevents a short from occurring between the battery cells 10 when the battery module 100 is conveyed and when connecting work is performed.

The casing 110 has a rectangular parallelepiped shape including six sidewalls 110a, 110b, 110c, 110d, 110e, and 110f. Inner surfaces of the sidewalls 110a to 110f of the casing 110 oppose the side surfaces Ea to Ef of the battery block 10BB, respectively (see Fig. 22).

On the sidewall 110a of the casing 110, an opening 105 having a rectangular shape is formed to extend in a vertical direction in the vicinity of the sidewall 100d. Two bus bars 501a and 501b are pulled out of the casing 110 via the opening 105.

Openings 106 and 107 in which the input connector 23a and the output connector 23c in the input/output harness 23H illustrated in Fig. 12 can be fitted, respectively, are formed in a substantially central portion of the sidewall 110a of the casing 110. The input connector 23a and the output connector 23c are fixed in a state protruding out of the casing 110 by being fitted in the openings 106 and 107, respectively, from within the casing 110.

Thus, the bus bars 501a and 501 b, the input connector 23a, and the output connector 23c are arranged to concentrate on one sidewall (the sidewall 110a in this example) of the casing 110 so that work efficiency for connecting a wiring between the battery modules 100 is improved.

A plurality of rectangular slits 108 extending in an axial direction (Y-direction) of the plurality of battery cells 10 (see Fig. 22) are formed to be arranged in a direction in which the plurality of battery cells 10 line up (X-direction) on the sidewall 110e of the casing 110. A plurality of rectangular slits 109 extending in an axial direction (Y-direction) of the plurality of battery cells 10 are formed to be arranged in the direction in which the plurality of battery cells 10 line up (X-direction) on the sidewall 110f of the casing 110. Cooling air can flow into the casing 110 via the slits 108 and 109, and can flow outward.

### (3) Example of Detailed Configuration of Battery System

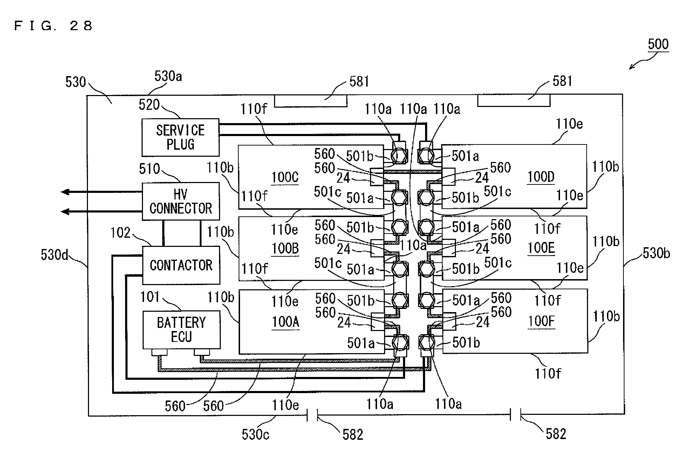

Fig. 28 is a schematic plan view illustrating one example of a detailed configuration of a battery system 500 according to the sixth embodiment. As illustrated in Fig. 28, the battery system 500 includes a plurality of (six) battery modules 100, a battery ECU 101, a contactor 102, an HV (High Voltage) connector 510, a service plug 520, and two fans 581.

In Fig. 28, the six battery modules 100 in the battery system 500 are referred to as battery modules 100A, 100B, 100C, 100D, 100E, and 100F, respectively, to distinguish one from the other.

The battery modules 100A to 100F, the battery ECU 101, the contactor 102, the HV connector 510, and the service plug 520 are housed in a box-shaped casing 530.

The casing 530 includes sidewalls 530a, 530b, 530c, and 530d. The sidewalls 530a and 530c are parallel to each other, and the sidewalls 530b and 530d are parallel to each other and are perpendicular to the sidewalls 530a and 530c.

One of the fans 581 is attached to the sidewall 530a of the casing 530 to oppose the sidewall 110f of the battery module 100C. The other fan 581 is attached to the sidewall 530a of the casing 530 to oppose the sidewall 110e of the battery module 100D. Exhaust ports 582 are formed on the sidewall 530c of the casing 530 to oppose the sidewall 110e of the battery module 100A and the sidewall 100f of the battery module 100F, respectively.

Within the casing 530, the battery modules 100C, 100B, and 100A are arranged to line up at predetermined spacings in a direction parallel to the sidewalls 530b and 530d in this order. The battery modules 100D, 100E, and 100F are arranged to line up at predetermined spacings in a direction parallel to the sidewalls 530b and 530d in this order. In this case, the battery modules 100A to 100F are attached to the casing 530 so that the sidewall 110d (see Fig. 27) of the casing 110 is directed upward. Thus, the plurality of battery cells 10 in the battery block 10BB are arranged so that their axes are parallel to one another in the vertical direction. In this case, work for connecting the wiring between the battery modules 100, described below, can be performed from an upper surface of the casing 530. As a result, work efficiency for connecting the wiring between the battery modules 100 is improved.

A bus bar 501b in the battery module 100A and a bus bar 501a in the battery module 100B are connected to each other through a connection bus bar 501c while a bus bar 501b in the battery module 100B and a bus bar 501a in the battery module 100C are connected to each other through a connection bus bar 501c.

A bus bar 501b in the battery module 100D and a bus bar 501a in the battery module 100E are connected to each other through a connection bus bar 501c while a bus bar 501b in the battery module 100E and a bus bar 501a in the battery module 100F are connected to each other through a connection bus bar 501c. Further, the service plug 520 is interposed between a bus bar 501b in the battery module 100C and a bus bar 501a in the battery module 100D.

A bus bar 501a in the battery module 100A and a bus bar 501b in the battery module 100F are connected to the HV connector 510 through the contactor 102. The HV connector 510 is connected to a load such as a motor in the electric vehicle. Thus, electric power generated in the battery modules 100A to 100F connected in series can be supplied to the motor or the like.

Within the casing 530, the output connector 23c (see Fig. 27) in the battery module 100A is connected to the input connector 23a (see Fig. 27) in the battery module 100B through a harness 560. The output connector 23c in the battery module 100B is connected to the input connector 23a in the battery module 100C through a harness 560. The output connector 23c in the battery module 100C is connected to the input connector 23a in the battery module 100D through a harness 560. The output connector 23c in the battery module 100D is connected to the input connector 23a in the battery module 100E through a harness 560. The output connector 23c in the battery module 100E is connected to the input connector 23a in the battery module 100F through a harness 560.

Further, each of the input connector 23a in the battery module 100A and the output connector 23c in the battery module 100F is connected to the battery ECU 101 through a harness 560. Thus, cell information of the battery modules 100A to 100F are fed to the battery ECU 101.

### [7] Seventh Embodiment

A battery module 100 according to a seventh embodiment will be described by referring to differences from the battery module 100 according to the sixth embodiment.

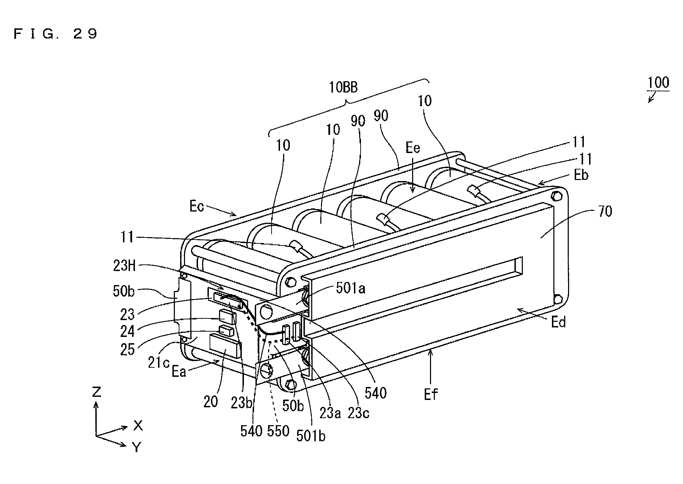

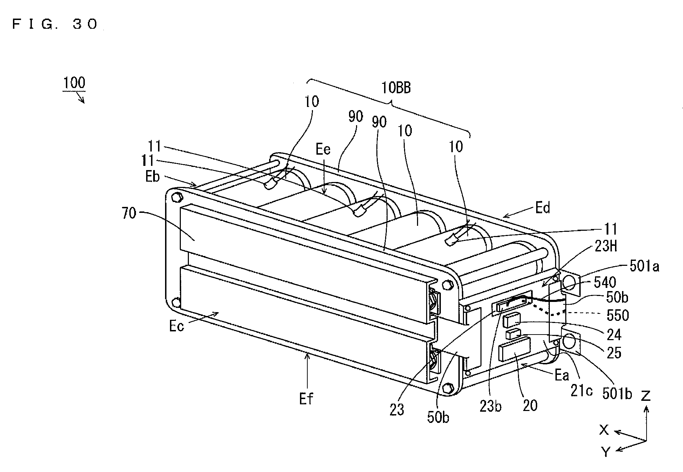

Fig. 29 is an external perspective view on one side of the battery module 100 according to the seventh embodiment, and Fig. 30 is an external perspective view on the other side of the battery module 100 illustrated in Fig. 29.

As illustrated in Figs. 29 and 30, the battery module 100 according to the present embodiment is not housed in the casing 110 illustrated in Fig. 27. The battery module 100 is provided with a terminal cover 70 to cover electrodes 10a and 10b on a side surface Ed and an FPC board 50. Similarly, the battery module 100 is provided with a terminal cover 70 to cover electrodes 10a and 10b on a side surface Ec and an FPC board 50.

An input/output harness 23H illustrated in Fig. 12 is used to connect a communication circuit 24 in a plurality of battery modules 100. In Figs. 29 and 30, harnesses 540 and 550 in the input/output harness 23H are indicated by a solid line and a dotted line, respectively.

A relay connector 23b is connected to a connector 23 on a printed circuit board 21c, and each of an input connector 23a and an output connector 23c is connected to other battery modules 100 so that cell information received from the other battery module 100 is input to the communication circuit 24 via the input connector 23a and the relay connector 23b. Cell information output from the communication circuit 24 is transmitted to the other battery module 100 via the relay connector 23b and the output connector 23c.

In this example, the input connector 23a and the output connector 23c in the input/output harness 23H are fixed on the side surface Ed of a battery block 10BB. Thus, the harnesses 540 and 550 for connecting the communication circuit 24 and the other battery module 100 are pulled out sideward from the printed circuit board 21c. Conductor lines 52 (see Fig. 8) for connecting a detection circuit 20 and a plurality of bus bars 40 and 40a, respectively, are pulled out sideward from the printed circuit board 21c with the FPC boards 50 connected to the printed circuit board 21c.

In the battery module 100 according to the present embodiment, the harnesses 540 and 550 for communication and the conductor lines 52 for voltage detection are thus pulled out in the same direction (Y-direction) from the printed circuit board 21c. Thus, the conductor lines 52 and the harnesses 540 and 550 are arranged to concentrate in one direction of the printed circuit board 21c. Therefore, the printed circuit board 21c becomes easy to handle, and the battery module 100 becomes easy to assemble. Since the conductor lines 52 and the harnesses 540 and 550 do not exist around the printed circuit board 21c excluding the one direction, heat dissipation characteristics of the detection circuit 20 and the communication circuit 24 are improved.

In this example, the input connector 23a and the output connector 23c are arranged in a position adjacent to an end close to a side surface Ea on the side surface Ed of the battery block 10BB. Further, a bus bar 501a connected to a plus electrode of the first battery cell 10 and a bus bar 501b b connected to a minus electrode of the 12-th battery cell 10 are arranged to protrude from a position in the vicinity of the end close to the side surface Ea on the side surface Ed of the battery block 10BB, as illustrated in Fig. 22. Thus, the bus bars 501a and 501 b, the input connector 23a, and the connector 23c are arranged to concentrate so that work efficiency for connecting the battery module 100 to the other battery module 100 is improved.

### [8] Eighth Embodiment

A battery module 100 and a battery system 500 according to an eighth embodiment will be described by referring to differences from the battery module 100 and the battery system 500 according to the seventh embodiment.

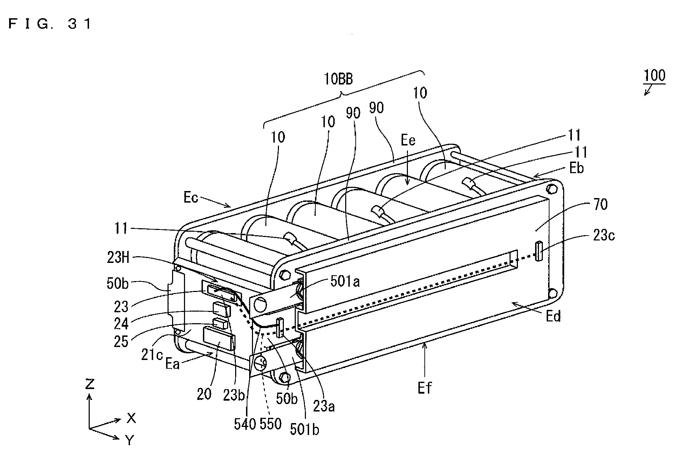

Fig. 31 is an external perspective view on one side of the battery module 100 according to the eighth embodiment. As illustrated in Fig. 31, an input/output harness 23H illustrated in Fig. 12 is used to connect communication circuits 24 in a plurality of battery modules 100. In Fig. 31, harnesses 540 and 550 in the input/output harness 23H are indicated by a solid line and a dotted line, respectively.

In this example, an input connector 23a is arranged in a position in the vicinity of an end close to a side surface Ea on a side surface Ed of a battery block 10BB. An output connector 23c is arranged in a position in the vicinity of an end close to a side surface Eb on the side surface Ed of the battery block 10BB.

When the plurality of battery modules 100 are arranged in the X-direction, a harness 560 (see Fig. 28) for connecting the input connector 23a and the other battery module 100 adjacent thereto can be shortened. A harness 560 for connecting the output connector 23c and the other battery module 100 adjacent thereto can be shortened.

### [9] Ninth Embodiment

A battery module 100 according to a ninth embodiment will be described by referring to differences from the battery module 100 according to the sixth embodiment.

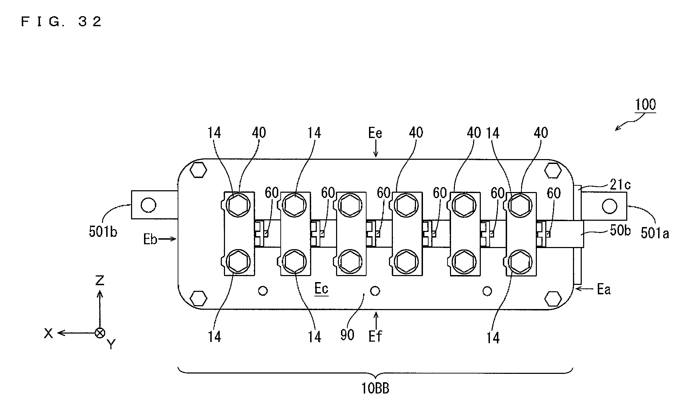

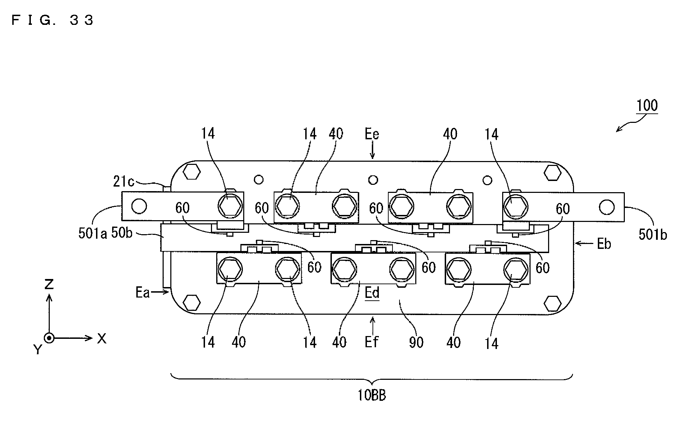

Details of the battery module 100 will be described. Fig. 32 is a side view on one side of the battery module 100 according to the ninth embodiment, and Fig. 33 is a side view on the other side of the battery module 100 illustrated in Fig. 32.

In the following description, similar to the sixth embodiment, out of six battery cells 10 arranged in an upper stage of a battery block 10BB illustrated in Figs. 32 and 33, the battery cell 10 closest to a side surface Ea to the battery cell 10 closest to a side surface Eb are referred to as first to sixth battery cells 10. Out of six battery cells 10 arranged in a lower stage of the battery block 10BB, the battery cell 10 closest to the side surface Eb to the battery cell 10 closest to the side surface Ea are referred to as seventh to 12-th battery cells 10.

As illustrated in Fig. 32, a bus bar 40 is attached so that a plus electrode and a minus electrode of the battery cells 10 adjacent in a vertical direction (Z-direction) are connected to each other on a side surface Ec of the battery module 100.

As illustrated in Fig. 33, on the side surface Ec of the battery module 100, one end of a bus bar 501a for supplying power to the exterior as the power supply line 501 illustrated in Fig. 1 is attached to the plus electrode of the first battery cell 10. One end of a bus bar 501b for supplying power to the exterior as the power supply line 501 illustrated in Fig. 1 is attached to the minus electrode of the sixth battery cell 10. The bus bar 40 is attached so that a plus electrode and a minus electrode of the battery cells 10 adjacent in a direction in which the plurality of battery cells 10 line up (X-direction), excluding the first and sixth battery cells 10, are connected to each other.

Thus, the plurality of battery cells 10 in the battery module 100 are connected in series. In the battery module 100, the plus electrode of the first battery cell 10 has the highest potential, and the minus electrode of the sixth battery cell 10 has the lowest potential.

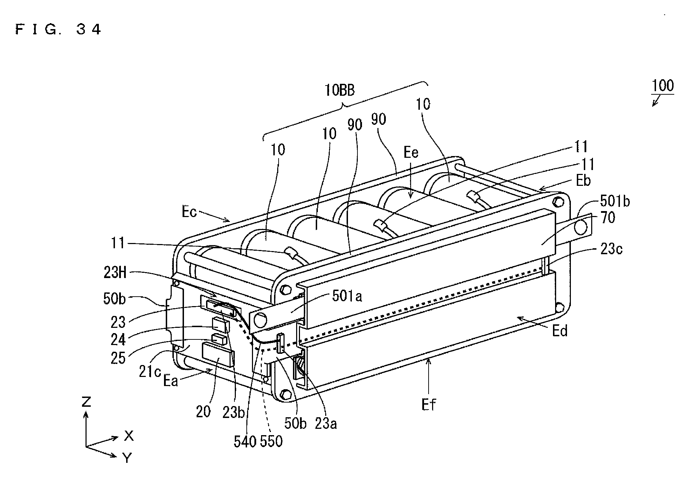

Fig. 34 is an external perspective view of the battery module 100 according to the ninth embodiment. As illustrated in Fig. 34, the input/output harness 23H illustrated in Fig. 12 is used to connect communication circuits 24 in the plurality of battery modules 100. In Fig. 34, harnesses 540 and 550 in the input/output harness 23H are indicated by a solid line and a dotted line, respectively.

A relay connector 23b is connected to a connector 23 on a printed circuit board 21c, and an input connector 23a and an output connector 23c are connected to the other battery modules 100, respectively, so that cell information received from the other battery module 100 is input to the communication circuit 24 via the input connector 23a and the relay connector 23b. Cell information output from the communication circuit 24 is transmitted to the other battery module 100 via the relay connector 23b and the output connector 23c.

In this example, the input connector 23a is arranged in a position in the vicinity of an end close to the side surface Ea on a side surface Ed of the battery block 10BB. The output connector 23c is arranged in a position in the vicinity of an end close to the side surface Eb on the side surface Ed of the battery block 10BB.

Thus, a harness 560 for connecting the input connector 23a and the other battery module 100 can be shortened. A harness 560 for connecting the output connector 23c and the other battery module 100 can be shortened.

A bus bar 501a connected to a plus electrode of the first battery cell 10 and the input connector 23a in the input/output harness 23H are arranged in a position in the vicinity of the end close to the side surface Ea on the side surface Ed of the battery block 10BB. Thus, the bus bar 501a and the input connector 23a are arranged to concentrate so that work efficiency for connecting the battery module 100 to the other battery module 100 is improved.

Similarly, a bus bar 501b connected to a minus electrode of the sixth battery cell 10 and the output connector 23c in the input/output harness 23H are arranged in a position in the vicinity of the end close to the side surface Eb on the side surface Ed of the battery block 10BB. Thus, the bus bar 501b and the output connector 23c are arranged to concentrate so that work efficiency for connecting the battery module 100 to the other battery module 100 is improved.

### [10] Tenth Embodiment

An electric vehicle according to a tenth embodiment will be described below. The electric vehicle according to the present embodiment includes the battery system 500 according to any of the first to ninth embodiments. In the following, an electric automobile is described as one example of the electric vehicle.

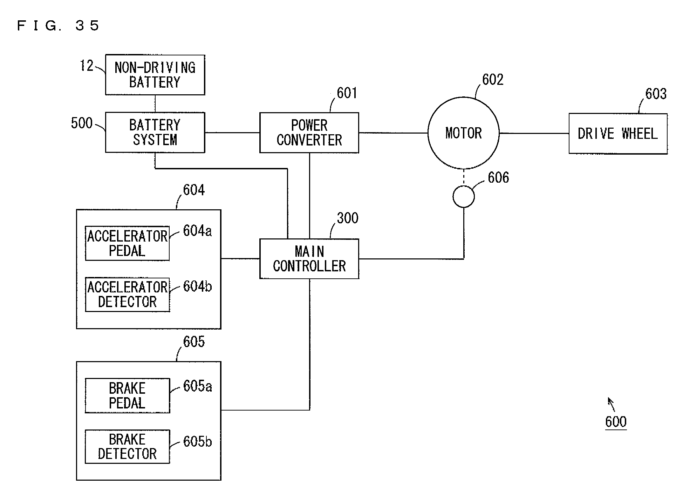

Fig. 35 is a block diagram illustrating a configuration of the electric automobile including the battery system 500. As illustrated in Fig. 35, an electric automobile 600 according to the present embodiment includes a non-driving battery 12, a main controller 300, and a battery system 500 illustrated in Fig. 1, a power converter 601, a motor 602, drive wheels 603, an accelerator system 604, a brake system 605, and a rotational speed sensor 606. When the motor 602 is an alternating current (AC) motor, the power converter 601 includes an inverter circuit.

As described above, the non-driving battery 12 is connected to the battery system 500 in the present embodiment. The battery system 500 is connected to the motor 602 through the power converter 601 while being connected to the main controller 300. As described above, charged capacities of a plurality of sets of battery modules 100 (Fig. 1) and a value of a current flowing through the battery module 100 are fed to the main controller 300 from the battery ECU 101 (Fig. 1) constituting the battery system 500. The accelerator system 604, the brake system 605, and the rotational speed sensor 606 are connected to the main controller 300. The main controller 300 is composed of a CPU and a memory or composed of a microcomputer, for example.

The accelerator system 604 includes an accelerator pedal 604a included in the electric automobile 600 and an accelerator detector 604b that detects an operation amount (depression amount) of the accelerator pedal 604a. When a driver operates the accelerator pedal 604a, the accelerator detector 604b detects an operation amount of the accelerator pedal 604a using a state where the driver does not operate the accelerator pedal 604a as a basis. The detected operation amount of the accelerator pedal 604a is fed to the main controller 300.

The brake system 605 includes a brake pedal 605a included in the electric automobile 600 and a brake detector 605b that detects an operation amount (depression amount) of the brake pedal 605a by the driver. When the driver operates the brake pedal 605a, the brake detector 605b detects the operation amount. The detected operation amount of the brake pedal 605a is fed to the main controller 300.

The rotational speed sensor 606 detects a rotational speed of the motor 602. The detected rotational speed is fed to the main controller 300.

As described above, the charged capacity of the battery module 100, the value of the current flowing through the battery module 100, the operation amount of the accelerator pedal 604a, the operation amount of the brake pedal 605a, and the rotational speed of the motor 602 are fed to the main controller 300. The main controller 300 performs charge/discharge control of the battery modules 100 and power conversion control of the power converter 601 based on the information.

Electric power generated in the battery modules 100 is supplied from the battery system 500 to the power converter 601 at the time of start-up and acceleration of the electric automobile 600 based on an accelerator operation, for example.

Further, the main controller 300 calculates a torque (commanded torque) to be transmitted to the drive wheels 603 based on the fed operation amount of the accelerator pedal 604a, and feeds a control signal based on the commanded torque to the power converter 601.

The power converter 601, which has received the control signal, converts the electric power supplied from the battery system 500 into electric power (driving power) required to drive the drive wheels 603. Thus, the driving power after the conversion by the power converter 601 is supplied to the motor 602, and the torque generated by the motor 602 based on the driving power is transmitted to the drive wheels 603.

On the other hand, the motor 602 functions as a power generation system at the time of deceleration of the electric automobile 600 based on a brake operation. In this case, the power converter 601 converts regenerated electric power generated by the motor 602 to electric power suitable for charging the battery modules 100, and supplies the electric power to the battery modules 100. Thus, the battery modules 100 are charged.

As described above, the electric automobile 600 according to the present embodiment is provided with the battery system 500 according to any of the first to ninth embodiments. Therefore, the battery ECU 101 can intensively manage cell information of the plurality of battery modules 100 while preventing the battery cells 10 from deteriorating. This can improve the reliability of the battery modules 100 and lengthens the life thereof. As a result, the performance of the electric automobile 600 can be improved while the cost thereof can be reduced.

### [11] Other Embodiments

(1) While in the battery modules 100 according to the above-mentioned embodiments, a detection circuit 20 and a communication circuit 24, which are separate from each other, are provided on each of the printed circuit boards 21 and 21a to 21c, the present invention is not limited to this. One circuit having the function of the detection circuit 20 and the function of the communication circuit 24 may be provided on each of the printed circuit boards 21 and 21a to 21c. In this case, the circuit is easily mounted on each of printed circuit board 21 and 21a to 21c while the cost of the battery module 100 can be reduced.

While in the battery modules 100 according to the above-mentioned embodiments, a lithium-ion battery is used as the battery cell 10, the present invention is not limited to this. For example, another secondary battery such as a nickel metal hydride battery can also be used.

(2) While in the first to fifth embodiments, the batter cell 10 having a flat and substantially rectangular parallelepiped shape is used, the present invention is not limited to this. For example, a laminate-type battery cell 10 having a plus electrode and a minus electrode at its one end may be used.

(3) While in the sixth to ninth embodiments, the cylindrical battery cell 10 is used, the present invention is not limited to this. For example, a laminate-type battery cell 10 having a plus electrode and a minus electrode at each of its one end and the other end may be used.

### [12] Correspondences between Elements in the Claims and Parts in Embodiments

In the following paragraphs, non-limiting examples of correspondences between various elements recited in the claims below and those described above with respect to various preferred embodiments of the present invention are explained.

In the embodiments, described above, the other battery modules 100 and 100A to 100F or the battery ECU 101 are examples of an external device, the battery cell 10 is an example of a battery cell, the detection circuit 20 is an example of a detector, the communication circuit 24 is an example of a communication unit, and the printed circuit boards 21 and 21a to 21c are examples of a circuit board. The plus electrode 10a or the minus electrode 10b is an example of an electrode, the bus bars 40 and 40p and the voltage/current bus bar 40y are examples of a connecting member, the conductor line 52 is an example of a first wiring, and the conductor lines 54 and 55 and the communication lines 56 and 58 are examples of a second wiring. The thermistor 11 is an example of a temperature detector, the conductor line 53 is an example of a third wiring, the FPC boards 50, 50a, and 50b are examples of a flexible member, the ground pattern GND1 is an example of a first ground conductor, and the first mounting region 10G is an example of a first region. The non-driving battery 12 is an example of an external power source, the ground pattern GND2 is an example of a second ground conductor, the second mounting region 12G is an example of a second region, the insulating region 26 is an example of a third region, and the insulating element 25 is an example of an insulating element. The battery ECU 101 is an example of a controller, the battery system 500 is an example of a battery system, the motor 602 is an example of a motor, the drive wheels 603 are examples of drive wheels, and the electric automobile 600 is an example of an electric vehicle.

As each of various elements recited in the claims, various other elements having configurations or functions described in the claims can be also used.

### [Industrial Applicability]

The present invention is applicable to various movable objects using electric power as a driving source, an electric power storage, or a mobile device.

## Claims

1. A battery module that can communicate with an external apparatus, comprising:
a plurality of battery cells;
a detector that detects a voltage of each of the battery cells;
a communication unit that is connected to said detector while being connectable to said external apparatus; and
a common circuit board on which said detector and said communication unit are mounted,
wherein said communication unit is operable to transmit the voltage of each of the battery cells detected by said detector to said external apparatus.

2. The battery module according to claim 1, further comprising
a connecting member that connects electrodes of the adjacent battery cells to each other,
a first wiring that connects said detector with said connecting member, and
a second wiring that connects said communication unit with said external apparatus,
wherein said first wiring and said second wiring are pulled out in the same direction from said circuit board.

3. The battery module according to claim 2, wherein said connecting member includes a plurality of connecting members, said first wiring includes a plurality of first wirings provided to correspond to said plurality of connecting members, and at least parts of said plurality of first wirings and said second wiring are pulled out in the same direction from said circuit board.

4. The battery module according to claim 2, further comprising
a temperature detector that detects temperatures of said plurality of battery cells,
a third wiring that connects said communication unit with said temperature detector, and
a flexible member that is provided with said first wiring, said second wiring, and said third wiring.

5. The battery module according to claim 1, wherein
said circuit board includes
a first region in which said detector is mounted while a first ground conductor for said plurality of battery cells is formed,
a second region in which said communication unit is mounted while a second ground conductor for an external power source is formed,
a third region for electrically insulating said first region and said second region from each other, and
an insulating element that connects said detector with said communication unit so that they can communicate with each other while being electrically insulated from each other.

6. A battery system comprising:
the plurality of battery modules according to claim 1; and
a controller that controls charge and discharge of each of the battery cells in said plurality of battery modules,
wherein the communication unit in each of the battery modules is connected to a communication unit in the other battery module, and said controller is connected to a communication unit in any one of the battery modules.

7. An electric vehicle comprising:
the battery system according to claim 6;
a motor that is driven by electric power form said battery module in said battery system; and
a drive wheel that rotates by a torque generated by said motor.
